# EUROPEAN PATENT SPECIFICATION

(11) **EP 4 326 568 B1**
(45) Date of publication and mention of the grant of the patent: **28.05.2025**
(21) Application number: 22723772.4
(22) Date of filing: 22.04.2022
(51) Int. Cl.: B60G 7/00, B62D 21/15, B60L 8/00, B62D 23/00, B62D 25/06, B62D 29/04, B62D 33/027, B60G 3/20, B60J 5/04, B60K 17/354, B60K 1/00, B60K 16/00, B60L 3/00, B60L 53/22, B60L 58/21, H01L 31/048, H02S 10/40, H02S 20/30, H02S 50/00

(54) **SUSPENSION FOR ELECTRIC VEHICLE**
ELEKTROFAHRZEUG MIT VERBESSERTER STRUKTUR
VÉHICULE ÉLECTRIQUE À STRUCTURE AMÉLIORÉE

(30) Priority: 23.04.2021 IT 202100010361
(43) Date of publication of application: 28.02.2024
(73) Proprietor: Interactive Fully Electrical Vehicles S.r.l., 10040 La Loggia (Torino) (IT)
(72) Inventor: PERLO, Pietro, 10040 La Loggia (Torino) (IT); PENSERINI, Davide, 10040 La Loggia (Torino) (IT); BIASIOTTO, Marco, 10040 La Loggia (Torino) (IT); GROSSO, Marco, 10040 La Loggia (Torino) (IT); POZZATO, Sergio, 10040 La Loggia (Torino) (IT); DALMASSO, Marco, 10040 La Loggia (Torino) (IT); SIVIERI, Simone, 10040 La Loggia (Torino) (IT); INTROZZI, Riccardo, 10040 La Loggia (Torino) (IT); MANCUSO, Antonio, 10040 La Loggia (Torino) (IT); USIGNOLO, Alessandro, 10040 La Loggia (Torino) (IT); DEPASQUALE, Sandro, 10040 La Loggia (Torino) (IT)
(74) Representative: Buzzi, Notaro & Antonielli d'Oulx S.p.A.
(86) International application number: PCT/IB2022/053767
(87) International publication number: WO 2022/224210

(56) References cited:
- WO-A1-2018/065946
- JP-A- H0 834 219
- JP-A- H10 129 225
- US-A1- 2004 021 286
- US-A1- 2018 312 025

## Description

### Field of the invention

The present invention relates to electric vehicles.

A preferred application of the invention relates to electric vehicles for transporting people of the van or pick-up type. However, the disclosures at the basis of the present invention are of general application.

The invention relates, in particular, to an electric vehicle of the type comprising:
- a frame, including a main cell module, a front anti-crash module rigidly connected to a front portion of the main cell module, and a rear frame module rigidly connected to a rear portion of the main cell module,
- wherein each of said frame modules consists of a reticular structure formed by high-strength steel arms, welded together, each arm having a hollow structure with a quadrangular cross-section,
- a front axle unit and a rear axle unit, each comprising:
   - an axle frame rigidly connected to a respective front or rear frame module,
   - an upper pivoting arm and a lower pivoting arm for each wheel of the axle unit, mounted hinged to the frame of the axle unit and carrying a respective wheel support in a rotatable way around a steering axis,
   - a wheel hub rotatably supported by each wheel support,
   - an electric motor unit carried by the axle frame and connected by means of transmission members to the wheel hubs of the two wheel supports, and
   - a device for activating the steering of the wheels, carried by the frame of the axle unit,
said vehicle further comprising a floor rigidly connected to two lower side longitudinal members of said main cell module, and configured to act as a structural element of the vehicle frame, and also as a container for the battery pack, for the electrical power supply of said electric motor assemblies associated with the two axle units.

### Prior art

The Applicant is the owner of various patents and patent applications (see, for example, WO2015/155697 A1, WO2015/145285, WO2016/055873 A1, WO2016/055874 A1, WO2018/065946 A1) relating to an electric vehicle of the type indicated above. The Applicant's continuous research and experience in relation to the development of this vehicle have led to a breakthrough in the field of small electric vehicles, usable as city cars, or as small commercial vehicles, minivans or mini pickups.

A first objective that the Applicant intends to achieve is that of a drastic reduction of the investment costs necessary to implement a series production of vehicles of this type. The conventional technique used in the construction of motor-vehicle bodies and their sub-assemblies is very complex and requires the provision of expensive production equipment. It follows that for each new model to be introduced into production it is necessary to envisage a significant economic investment, which often constitutes a limit for vehicle manufacturers to the possibility of reacting promptly to market demands.

The structure of the frame of the electric vehicle, which was developed by the Applicant, and which was the subject of the patent documents identified above, allows drastic reduction of the costs of the production equipment of the motor-vehicle. This was achieved in the first place by replacing the traditional body, consisting of pressed metal sheet elements welded together, with a reticular frame having the configuration described above. Production in series of a frame of this type does not require the preparation of complex, bulky and expensive production structures.

Furthermore, configuration of the vehicle frame developed by the Applicant also has the advantage of being able to be configured not only in such a way as to easily pass all the crash tests required by regulations, but also to give the entire structure a degree of safety and of very high impact energy absorption capacity.

In continuing his research and development activity, the Applicant has again identified the possibility of further improvements in terms of simplifying the construction of the vehicle and in terms of the resistance characteristics and the capacity of absorbing impact energy of the vehicle structure.

More generally, an additional objective that the Applicant intends to achieve is that of further simplifying the construction of the vehicle, maintaining and preferably improving the level of safety that the vehicle achieves in terms of protection of the driver and passengers in the event of a crash.

An additional objective of the Applicant is that of producing a new electric vehicle configuration, usable particularly as a minivan or mini pick-up. In particular, the Applicant intends to provide a new vehicle configuration of this type, which can exploit in a particularly efficient way an arrangement of photovoltaic cells arranged on the outer surfaces of the vehicle, and usable for recharging the battery pack of the electric vehicle.

Yet another problem that the Applicant intends to solve is that of drastically improving the efficiency of the recharging process of the battery pack of the electric vehicle, both in the recharging phase by an outer power supply network, and in the recharging step while the vehicle is running, by means of a braking energy recovery system, and in a recharging step by photovoltaic cells with which the electric vehicle is equipped.

### Object of the invention

In view of the above, a first object of the invention is to further improve the vehicle previously proposed by the same Applicant, making its construction even simpler and cheaper.

An additional object of the invention is to produce a vehicle with a high capacity for absorbing impact energy and with a high degree of protection for the driver and passengers in the event of collisions.

An additional specific object of the present invention is to drastically simplify not only the construction of the vehicle frame, but also that of additional components, such as the suspension elements and the doors, consequently reducing the investment costs necessary to prepare the corresponding production.

An additional object of the invention is to propose a new electric vehicle configuration of the type indicated above, usable in particular for vehicles of the van or pick-up class, wherein it is possible to provide an extensive and - at the same time - efficient use of arrays of photovoltaic cells that can be used to recharge the vehicle battery pack.

An additional object of the invention is to propose a battery pack recharging system with the aid of photovoltaic panels that allows active balancing of the battery pack.

Finally, yet another object, no less important than the previous ones, that the present invention aims to achieve is to drastically improve the efficiency and duration of the battery pack by means of its dynamic reconfiguration during vehicle use.

### Summary of the invention

In view of achieving one or more of the aforesaid objects, the present invention relates to an electric vehicle having all the characteristics disclosed at the beginning of this description and also characterized in that:
- said upper pivoting arm and said lower pivoting arm associated with each wheel each have a main body consisting of elements obtained from high-resistance steel tubes cut by laser cutting and welded together, with an upper main wall and a lower main wall, both triangular in shape, parallel and spaced apart, defining a base side of the triangular configuration at the ends of which two horizontal bushings are welded coaxial with each other, for the articulated connection to the frame of the respective axle unit, and with an outer tip of the triangle configuration to which a vertical axis bushing is welded for the articulated connection of the wheel support around the steering axis,
   also the wheel support, connected to said upper pivoting arm and to said lower pivoting arm, has a main body consisting of tubular members in high resistance steel welded together,
- a cylindrical ring for the rotatable support of the wheel hub is welded to said main body of the wheel support, and
- an upper attachment and a lower attachment are welded to said main body of the wheel support, also made of high-strength steel tubes and welded together, intended to receive articulated supports for the rotatable connection to the upper and lower pivoting arms around said steering axis.

Thanks to the aforesaid characteristics, the structure of the suspension elements, consisting of the upper arm and the lower arm carrying each wheel support, and the wheel support, is also drastically simplified.

Another characteristic of the invention lies in the fact that the aforesaid floor also acting as a container for the battery pack (BP) has a structure including a lower container body and an upper container body having peripheral edges rigidly connected to each other,
wherein each of said lower and upper container bodies is formed by two metal sheet panels parallel to each other and spaced apart, shaped by cutting and bending, so as to present a main bottom wall surrounded by two side walls and two end walls,
wherein one or both of the two metal sheet panels of each container body has an ordered distribution of imprints, which act both as spacer elements between the two panels, and as stiffening elements, and
wherein the space between the two panels of each of said lower and upper container bodies acts as an insulating chamber, and may be filled with insulating material also having the function of reducing vibrations.

The structure of the floor of the vehicle according to the invention is, therefore, such as not to require any molding operation and consequently does not require the preparation of corresponding equipment. Each of the sheet metal panels is obtained starting from a semi-finished product obtained by a cutting operation and then brought into the final configuration by folding operations. The impressions acting as spacer elements are preliminarily made in the corresponding panel with equipment that can be greatly simplified.

Still according to an additional characteristic of the invention, the aforesaid front frame module includes longitudinal beams for absorbing impact energy, each consisting of an arm of the reticular structure, projecting forwards, having a hollow body with a quadrangular cross-section, in such a way as to have four longitudinal edges, and in that each of said longitudinal beams has a series of openings for controlling the impact deformation, formed on some or all of the aforesaid longitudinal edges in spaced apart positions, said openings presenting a decreasing amplitude from the front end of the beam towards the rear end, so as to induce a progressive deformation of the beam following a front impact, starting from the front end towards the rear end.

According to an additional characteristic, the vehicle comprises at least two front doors, articulated to the cell module of the vehicle frame, each comprising a door frame having opposite faces covered by an inner door structure and an outer door structure, wherein the door frame includes a reticular structure similar to that of the aforesaid frame modules, formed by high-strength steel arms, welded together, each arm having a hollow structure with a quadrangular cross-section, wherein said arms constituting the door frame include at least one front upright, and one rear upright, which are rigidly connected to each other by an upper cross-member, a lower cross-member and a diagonal arm, wherein each door includes a window frame defined by auxiliary elements substantially forming an arch, having the ends rigidly connected to said upper cross-member of the door frame, and wherein the inner door structure and the outer door structure are constituted by steel sheet panels rigidly connected on opposite sides to said door frame, and including respective window frames in a single piece, which clamp together the aforesaid arch connected to the upper cross-member of the door frame .

Thanks to the characteristics indicated above, the construction of the vehicle doors is radically simplified, while - at the same time - the diagonal arm forming part of the door frame constitutes an important protection for the safety of the driver and passengers in the event of side impacts.

According to an additional aspect, the invention relates to an electric vehicle of the type described above, characterized in that:
- the vehicle frame has a configuration for a pick-up or van including a superstructure formed by a front roll-bar, a rear roll-bar and two upper side longitudinal members and in that:
   - said superstructure supports:
      - an upper panel of photovoltaic cells serving as a roof,
      - two side panels of photovoltaic cells covering the two sides of said superstructure, and
      - a rear panel of photovoltaic cells covering the rear frame of said superstructure, and
wherein the aforesaid side panels and the aforesaid rear panel are movable between a lowered position, wherein the aforesaid panels cover the respective sides of said superstructure, so as to define a closed space, and a raised position, wherein the panels are rotated upward around one of their upper horizontal edges.

In one embodiment, in their raised position the side panels and the rear panel are arranged to slide under the roof panel.

Furthermore, in one example, the vehicle carries auxiliary panels of photovoltaic cells, which are arranged stationary on the sides and rear of the vehicle, below the aforesaid superstructure.

According to another characteristic, in each panel of photovoltaic cells, the cells are incorporated in a layered laminar structure, including an outermost layer comprising one or more layers of PET with a UV or ECTFE coating, two layers of a thermoplastic polyolefin material, above and below the cells, to encapsulate the cells, with a rear layer of structural glass fiber, which replaces the solutions based on a rear layer of PET with UV coating.

According to another preferred characteristic, each panel of photovoltaic cells has an ordered distribution in rows and columns of photovoltaic cells, separated by cell-free strips or zones, and in that in at least some of the intersections between the said cell-free strips or zones reflecting devices or LED light sources are arranged, configured to display - as an assembly - passive colored or reflective or active writings and/or logos through the LED sources.

According to another aspect, the invention comprises one or more outer surfaces covered by one or more panels of photovoltaic cells connected to a recharging circuit of the battery pack, which powers the electric drive motors of the vehicle, wherein:
- said battery pack comprises a plurality of battery modules or partitions connected in series with each other, so that the voltage across the battery pack (for example 48V or 120V or 360V, or 420V) is the sum of the voltages across the individual battery modules or partitions (for example, 24V or 30V or 60V, or more specifically at a voltage submultiple of the voltage of the entire battery pack),
- said recharging circuit comprises a switching circuit configured to connect one or more groups or panels of said photovoltaic cells, selectively to any of said battery modules or partitions in such a way that each battery partition module is supplied with current at the supply voltage of the single battery module-partition, (for example 24V, or more specifically, at a voltage submultiple of the voltage of the entire battery pack),
- each photovoltaic cell or each group or panel of photovoltaic cells is connected to said switching circuit by means of a DC/DC converter, which carries the current from the supply voltage of the cell (for example, between 3 V and 30 V) to the supply voltage of the single battery module (e.g. 24 V or more specifically at a voltage submultiple of the voltage of the entire battery pack), which is a submultiple of the voltage of the entire battery pack.

Thanks to this characteristic, the circuit components are simplified and cheaper, the efficiency of the charging process is improved, and the invention also allows application of active balancing of the pack partitions using photovoltaic cells.

In the preferred embodiment, a Battery Management System is associated with said battery pack, designed to control the state of charge of the individual battery modules, and an electronic control and processing unit, which is configured and programmed to control the aforesaid switching circuit depending on the state of charge of the individual battery modules, in such a way as to actively balance the battery module that is being recharged, in order to maintain a substantially uniform state of charge of the various battery modules.

Thanks to the aforesaid characteristic, the invention therefore allows an "active" balancing of the battery pack charge through photovoltaic cells.

In one example, each DC/DC converter has a first pole and a second pole at its output, and said switching circuit comprises a plurality of switches each designed to connect one of the two poles of a respective battery module with all the first output poles of the DC/DC converters or with all the second output poles of the DC/DC converters.

In a variant, which eliminates the risk that the aforesaid switches may be in a combination of operating states that gives rise to a short circuit, each DC/DC converter has a first pole and a second pole at its output, the switching circuit comprises a plurality of galvanic isolation circuits, each having two input heads and two output heads, the two output heads of each galvanic isolation circuit are connected to the two poles of a respective battery module, and the two input heads of each galvanic isolation circuit are connected one to all the first output poles of said DC/ DC converters and the other to all the second output poles of said DC/DC converters.

Also in the case of this second example, the battery pack is associated with a Battery Management System designed to control the state of charge of the individual battery modules, and an electronic control and processing unit, which is configured and programmed to control the aforesaid galvanic isolation circuits according to the state of charge of the individual battery modules, in such a way as to dynamically vary the battery modules that are being recharged, in order to balance the state of charge of the different battery modules.

According to another aspect, a Battery Management System is associated with the battery pack, configured to control the state of charge of the battery pack, and communicates with the inverter in such a way as to regulate the level of regenerative braking and, therefore, the flow of energy towards the battery, and possibly disable the regenerative braking when a battery charge state above a predefined level is detected.

According to another aspect which is not part of the invention, the electric vehicle comprises a circuit for recharging the vehicle battery pack by an external power supply network or, while the vehicle is running, by a braking energy recovery system. To improve the efficiency of the charging process, the vehicle is characterized in that:
- said battery pack comprises a plurality of battery modules,
- the vehicle comprises a connection circuit of said battery modules including a plurality of connection switches, each switchable between a first position and a second position, and
an electronic control and processing unit configured to control the switching of said connection switches in such a way that the voltage of the battery pack is adapted according to the state of use and in particular in such a way that:
- during a battery module recharge phase, said connection switches are in a first switching configuration, wherein the battery modules are connected in series with each other,
- when the electric vehicle is in motion, said connection switches are in a second switching configuration, wherein the battery modules are connected in parallel with each other or partially in series and partially in parallel, and
- when the electric vehicle is stationary with the electric motors inactive, said connection switches are in a third switching configuration, wherein the battery modules are isolated from each other.

Thanks to the aforesaid characteristics, the battery modules are connected in series with each other during the recharging phase, in order to increase the recharge voltage (for example, 200V or 300V or 400V and more) and, therefore, to keep the power supply current low in order to be able to increase the charging speed by reducing the stress of the battery cells. In the previous instant wherein recharging begins, the system of the switches prepares the entire pack to operate in the manner wherein the modules are connected in series.

In the configuration wherein the modules are disconnected from each other, the maximum voltage of the entire circuit is that of the single module, this configuration is, therefore, characterized by the safety wherein an operator can intervene on the pack avoiding the risks due to high voltage. Similarly, when the vehicle is stationary and not charging, the circuit of the switches autonomously disconnects the modules from each other. While running, the system of the switches can reconnect all the modules in series or reconfigure them in such a way as to supply a multiple voltage of the submodules, for example, in a configuration whereby the two-by-two modules operate in parallel and the two pairs in series.

### Description of preferred embodiments

Further characteristics and advantages of the invention will become apparent from the description that follows with reference to the attached drawings, provided purely by way of non-limiting example, wherein:
- Figure 1 is an exploded perspective view of the main components of the structure of the vehicle according to the invention, in an embodiment example,
- Figure 2 is a perspective view of an axle unit of the vehicle of Figure 1,
- Figures 3A, 3B are perspective views of an upper pivoting arm and a lower pivoting arm of the suspension of a wheel of the vehicle of Figure 1,
- Figure 4 is an exploded perspective view of the structure of a door of the vehicle of Figure 1,
- Figure 5 illustrates a perspective view of the frame of a front door and a rear door of the vehicle of Figure 1,
- Figure 6 is another embodiment example of the vehicle according to the invention, in a pick-up configuration,
- Figure 7 is a perspective view of a vehicle of the type of Figure 6 with a superstructure including two roll-bars,
- Figure 8 is a perspective view of another configuration of the pick-up vehicle of Figures 6, 7,
- Figure 9 illustrates the vehicle of Figure 8 with a plurality of panels carrying photovoltaic cells shown in their raised position,
- Figure 10 is a perspective view of an additional variant of the pick-up vehicle,
- Figure 11 is an additional perspective view of the variant of Figure 10,
- Figures 12-17 are perspective views and orthogonal views illustrating the frame of the vehicle in the pick-up and van configurations,
- Figure 18 is a perspective view of the detail of the elements of the suspension system of each wheel,
- Figure 19 is a perspective view on an enlarged scale of a wheel support,
- Figure 20 is a cross-sectioned perspective view of the floor of the vehicle according to the invention,
- Figure 21 is an exploded perspective view of the floor of Figure 20,
- Figures 22A-22D indicate four different operating conditions of a circuit for connecting the photovoltaic cells of which the vehicle is equipped with the various modules of a vehicle battery pack,
- Figure 23 is a variant of Figures 22A-22D,
- Figure 24 illustrates the overall scheme of energy management from the battery pack to the powertrain, to the on-board photovoltaic panels and to the network,
- Figure 25 illustrates a variant of the connection circuit between the photovoltaic cells and the battery modules suitable for the active balancing of the pack,
- Figures 26A, 26B illustrate additional diagrams of the variant of Figure 25,
- Figures 27-29 illustrate three different operating conditions of a connection circuit of the different battery modules suitable for dynamic configuration of the battery pack, with the vehicle being recharged from the mains, the vehicle stationary and the vehicle in motion,
- Figure 30 illustrates the stratified structure of each panel bearing the photovoltaic cells with which the vehicle according to the invention is provided, wherein the substrate is constituted by a thin structural element in glass fiber.

### General structure of the vehicle

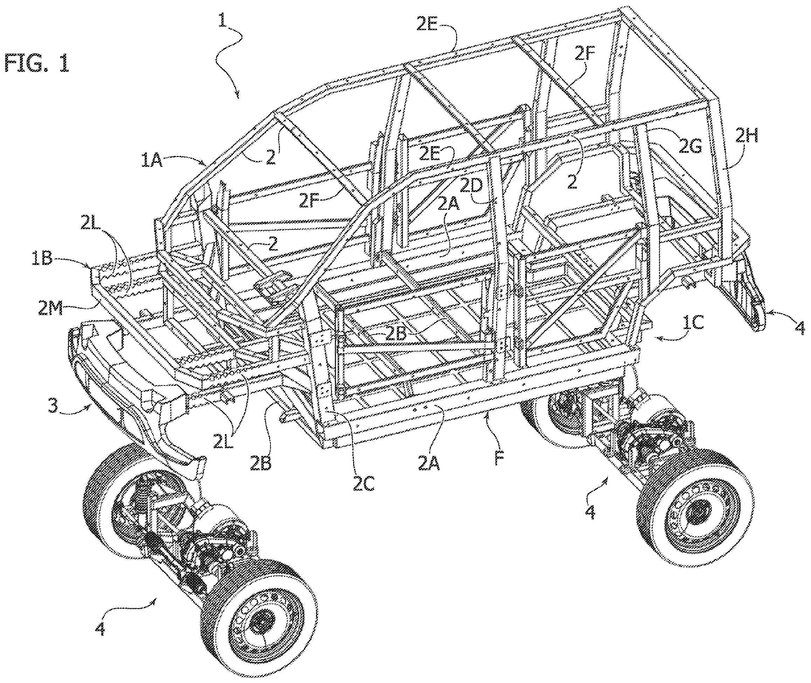

In Figure 1, reference 1 indicates - in its entirety - the frame of an electric vehicle, comprising a main cell module 1A, a front anti-crash module 1B rigidly connected to a front portion of the main cell module 1A, and a rear frame module 1C rigidly connected to a rear portion of the main cell module 1A.

Each of the modules 1A, 1B, 1C consists of a reticular structure formed by high-strength steel arms 2, welded together, each arm having a hollow structure with a quadrangular cross-section. With reference to the specific example illustrated, the main cell module 1A includes two lower side longitudinal members 2A connected to each other by cross-members 2B. The lower ends of two front side uprights 2C and two central side uprights 2D are welded to the longitudinal members 2A. In the example of Figure 1, the frame 1 also includes a superstructure wherein the arms 2 define two side beams 2E connected to each other by cross-members 2F. At the rear, in the illustrated example, additional side uprights 2G, 2H are provided, connected below to the rear frame module 1C and above to the side beams 2E.

The front frame module 1B has an upper part including four longitudinal beams 2L projecting forwards, the front ends of which are connected by a front cross-member 2M. The lower part of the module 1B includes two additional longitudinal beams 2L, also protruding forwards and ending with flanges for coupling with a crossbar (not visible in the drawing), forming part of the structure of a front bumper 3. The longitudinal beams 2L are configured in such a way as to be able to absorb impact energy, through their controlled deformation, as will be described in more detail below.

References 3 and 4 indicate the structure of the vehicle's front and rear bumpers intended to be connected to the front 1B and rear 1C frame modules. The front bumper, if produced in composite material according to a previous proposal by the same Applicant, has characteristics of particular stiffness and non-linear elasticity such as to improve performance in the event of a frontal and off-axis crash.

Connected to the two lower side longitudinal members 2A is a floor structure F, which will be described in more detail below, which performs both a structural function and container function for the battery pack of the vehicle.

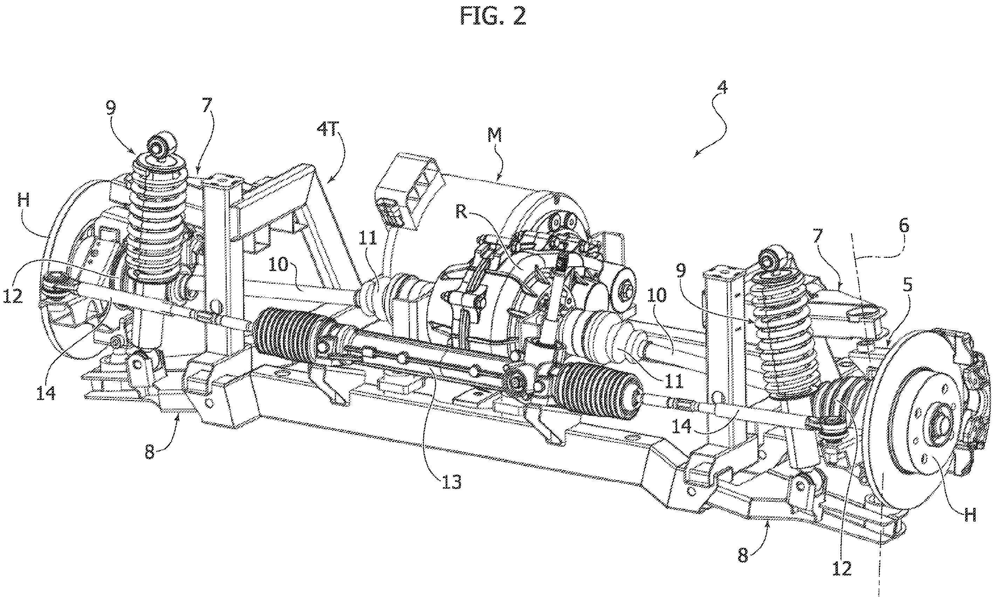

Still with reference to Figure 1, the vehicle comprises a front axle unit 4 and a rear axle unit 4, substantially identical to each other, each having a sub-frame 4T (see Figure 2) rigidly connected, respectively, to the front frame module 1B and to the rear frame module 1C.

### The axle unit

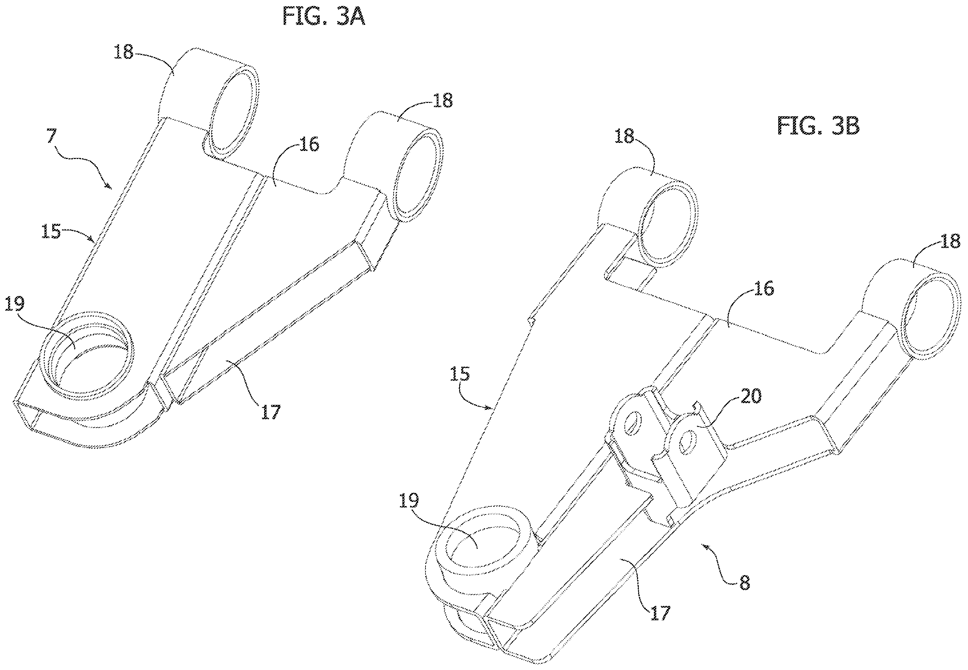

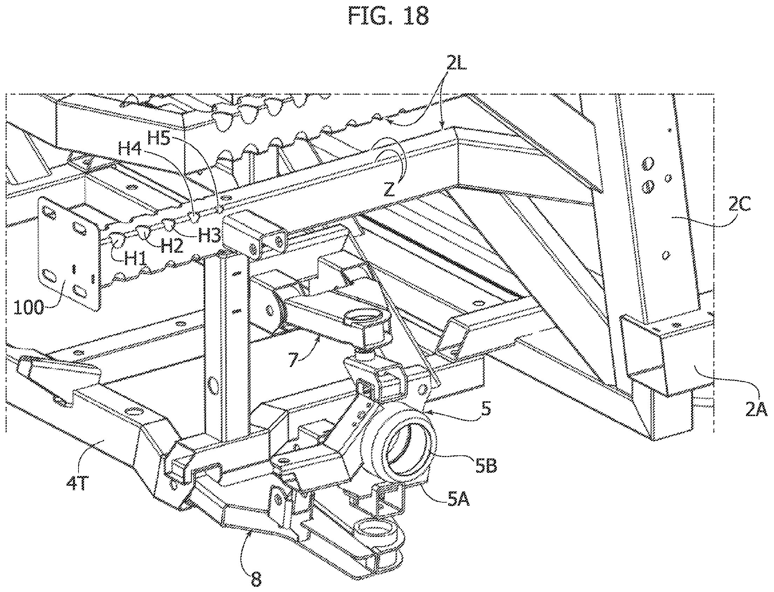

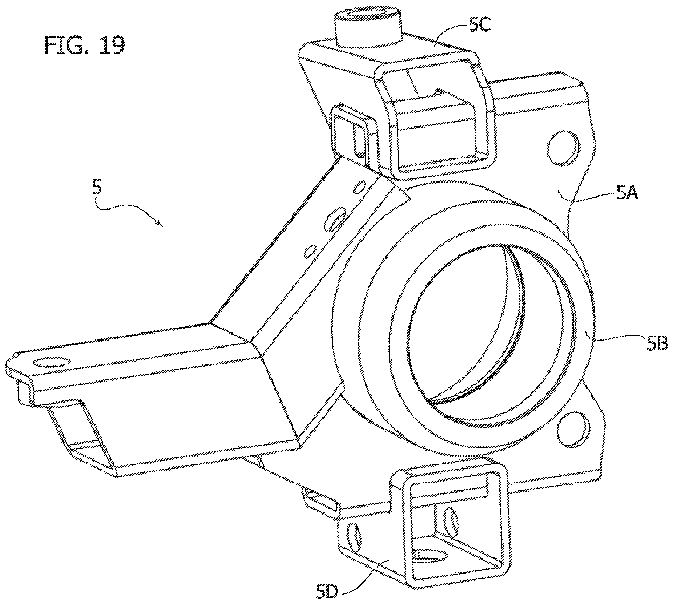

With reference to Figure 2, the axle unit 4 comprises, for each wheel, a wheel support 5, better visible in Figures 18 and 19, which is rotatably supported around a steering axis 6 by an upper pivoting arm 7 and by a lower pivoting arm 8, having a triangular configuration, better visible in Figures 3A, 3B. A spring-shock absorber assembly 9 is interposed between the lower triangle 8 and the frame 4T. Mounted on the frame 4T is a respective electric motor unit M connected by means of a gearbox unit R connected by means of homokinetic joints 11 to two shafts 10 which are - in turn - connected by means of homokinetic joints 12 to the wheel hubs H rotatably supported by the wheel supports 5. The frame 4T also carries a steering actuation device 13 connected by means of articulated tie rods 14 to the two wheel supports 5. In the preferred fourwheel drive configuration, the two axles are substantially identical, but they may differ in the ratio of the gearbox unit, for example, in one axle the reduction ratio may be 1:9 while in the other axle 1:6.5. The two axle units may operate completely independently or be controlled by a centralized controller that manages the torque delivery in the two axles in order to improve the stability of the vehicle in the presence of rain or in dangerous curves.

### The pivoting arms of the suspension

With reference to Figures 3A, 3B, the pivoting arms 7 and 8 of the suspension of each wheel each have a main body 15 made up of high resistance steel tubes cut with laser technique and joined by electrowelding, with an upper main wall 16 and a lower main wall 17, triangular in shape, parallel to each other and spaced apart. Two horizontal bushings, 18 coaxial with each other, are welded on the inner side of the triangular body 15, for articulated connection of the pivoting triangle to the frame 4T of the axle unit. On the other hand, a bushing 19 with a vertical axis is welded to the outer tip of the triangular body 15, for articulated connection of the wheel support around the steering axis.

Figure 18 of the attached drawings shows the detail of the connection of the wheel support 5 to the pivoting triangles 7, 8. The hinging device which allows the wheel support 5 to rotate around the steering axis 6 is arranged inside each bushing 19.

Again with reference to Figure 3B, a bracket 20 is also welded on the main body 15 of the lower triangle 8 for attaching the lower end of the spring-shock absorber assembly 9.

As is evident from the above description, the structure of the pivoting triangles 7, 8 allows a considerable simplification of the manufacturing operations and also a drastic reduction of the costs of the production equipment, given that it is not necessary to prepare elements obtained from molding or casting processes, since it is possible to make each component by simply bending and welding metal sheet elements.

With reference to Figure 19, the same concept has also been applied to the preferred embodiment for the wheel supports 5. Indeed, each wheel support 5 has a main body 5A consisting of tubular members in high-resistance steel cut with laser cutting and joined by electrowelding. A cylindrical ring 5B for the rotating support of the wheel hub H is welded to the main body 5A. An upper attachment 5C and a lower attachment 5D are also welded to the main body 5A, which are also made up of electro-welded tubular steel members, designed to carry the articulation pins, which are received in the hinge devices carried by the upper triangle 7 and the lower triangle 8.

### The doors of the vehicle

Again with reference to Figures 1 and 4, 5, the vehicle configuration illustrated in Figure 1 is equipped with two front side doors and two rear side doors.

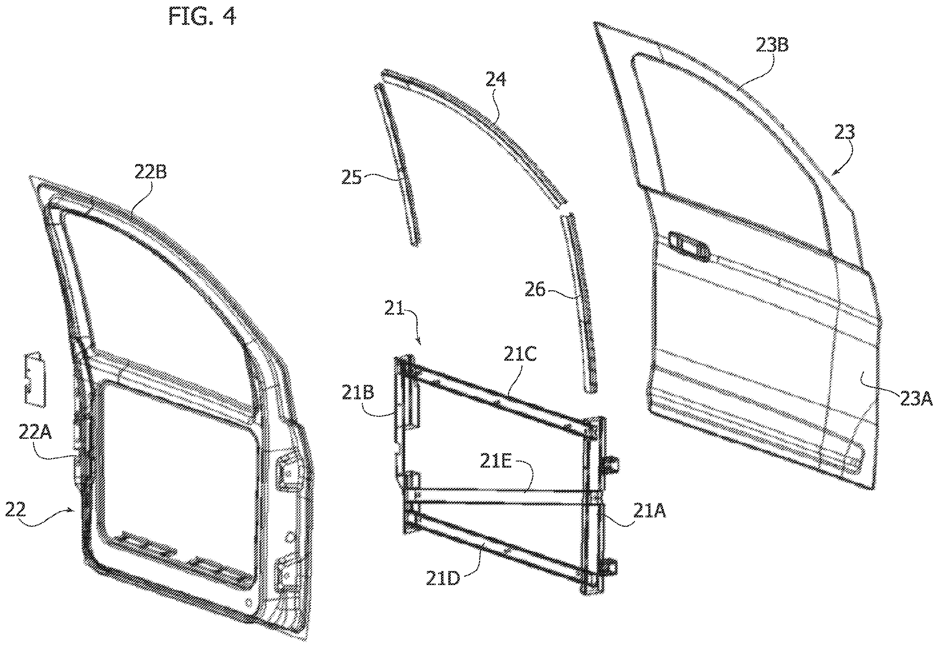

Figure 4 shows an exploded view of the structure of a front side door, comprising a door frame 21 comprised between an inner door structure 22 and an outer door structure 23. The door frame 21 presents a reticular structure similar to that of the frame modules of the vehicle, formed by high-strength steel arms, welded together, each arm having a hollow structure with quadrangular cross-section. In particular, the arms constituting the door frame 21 include one front upright 21A, and one rear upright 21B, which are connected to each other by an upper cross-member 21C, by a lower cross-member 21D and by a diagonal arm 21E.

Still with reference to Figure 4, the door also includes a window frame defined by guiding elements 24, 25, 26 defining an arched configuration having the opposite ends welded to the upper cross-member 21C of the door frame 21. The inner door structure 22 and the outer door structure 23 are in the form of metal sheet panels, which are coupled together keeping the door frame 21 interposed between them. Each panel 22, 23 includes a lower portion 22A, 23A, and an upper window frame 22B, 23B. The two frames 22B, 23B are coupled to each other and clamp the guide elements 24-26 together.

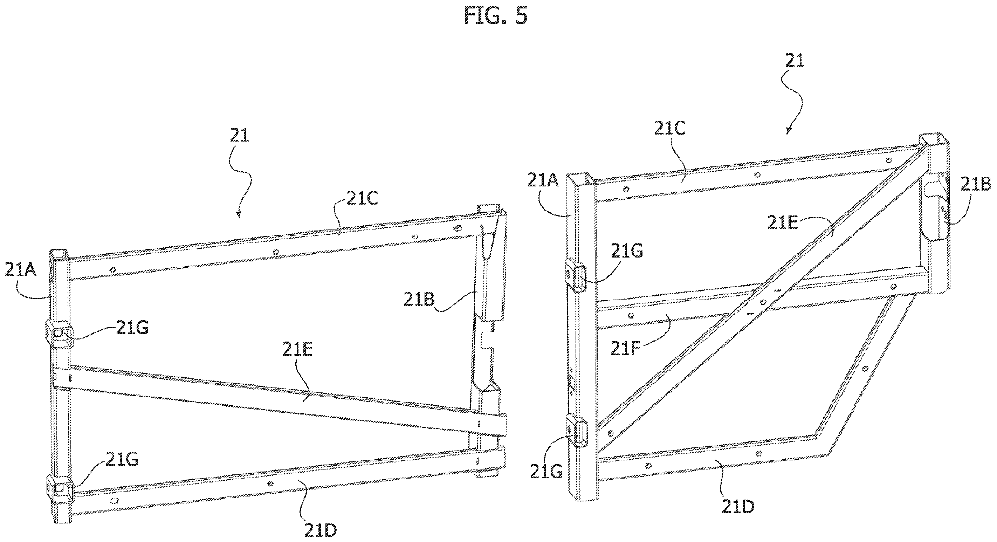

The structure of the rear door is substantially similar to that of the front door shown in Figure 4. Figure 5 shows the skeleton-frames 21 of the front door and the rear door. The frame-skeleton 21 of the rear door also includes uprights 21A, 21B connected together by an upper cross-member 21C and a lower cross-member 21D, which has an angled configuration as a consequence of the need to leave a free space occupied by the rear wheel fender. The frame-skeleton 21 of the rear door also has a diagonal arm 21E, and has an additional intermediate horizontal cross-member 21F, which connects the uprights 21A, 21B to each other in an intermediate position between the upper and lower cross-members 21C, 21D. The front upright 21A of each door frame-skeleton 21 carries brackets 21G for mounting the door hinging devices to the respective upright 2C or 2D of the vehicle frame.

As is evident from the above description, in the vehicle according to the invention the doors also have a structure configured to allow - on the one hand - a drastic simplification of the manufacturing operations and a reduction in the cost of the production equipment and, however, to achieve - on the other hand - a high degree of safety and protection of passengers against the consequences of side impacts.

### Pick-up configuration

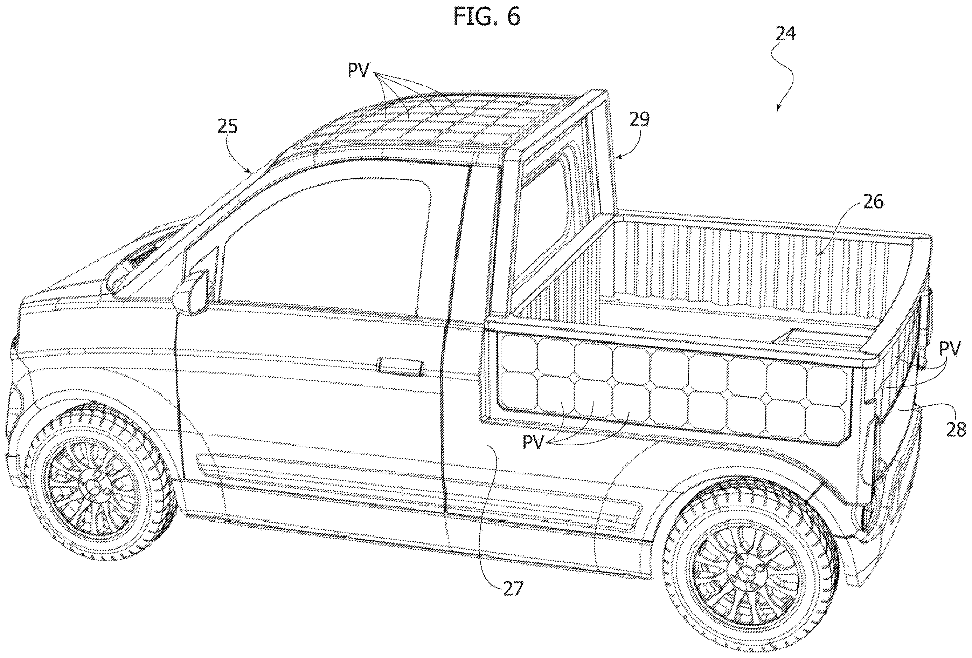

Figure 6 illustrates a configuration of the electric vehicle according to the invention in the form of a pick-up. The vehicle, indicated - in its entirety - by the reference number 24, comprises a cabin 25 and a rear body 26 delimited by two side walls 27 and a rear wall 28. In the preferred embodiment illustrated here, the aforesaid walls have panels of photovoltaic cells PV, the structure of which will be described below.

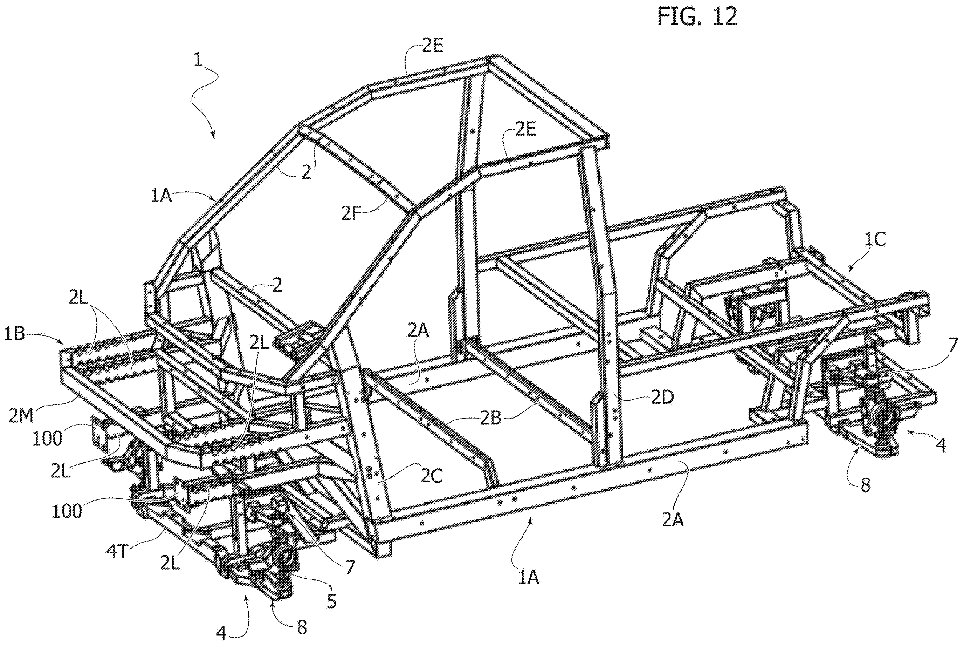

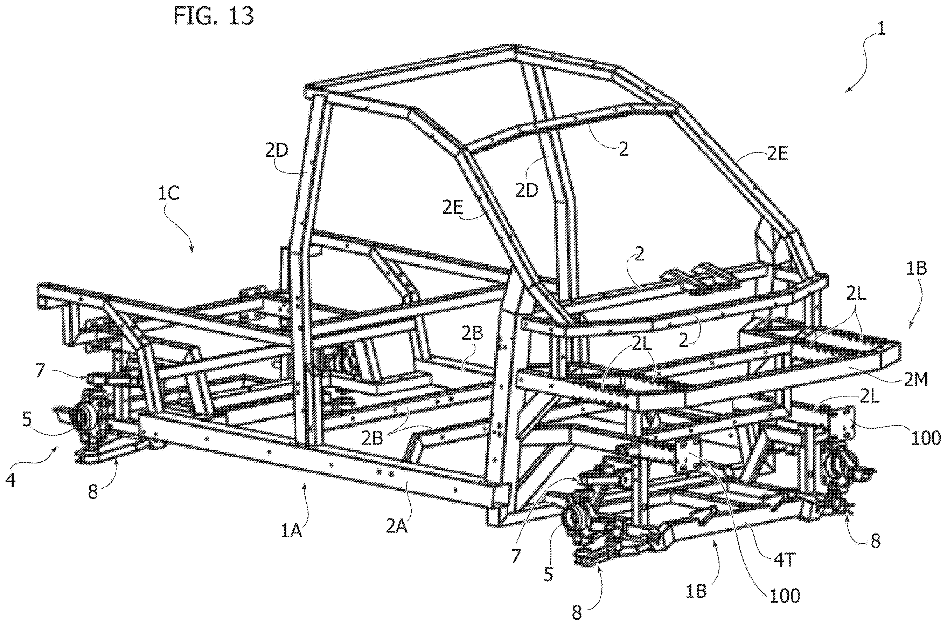

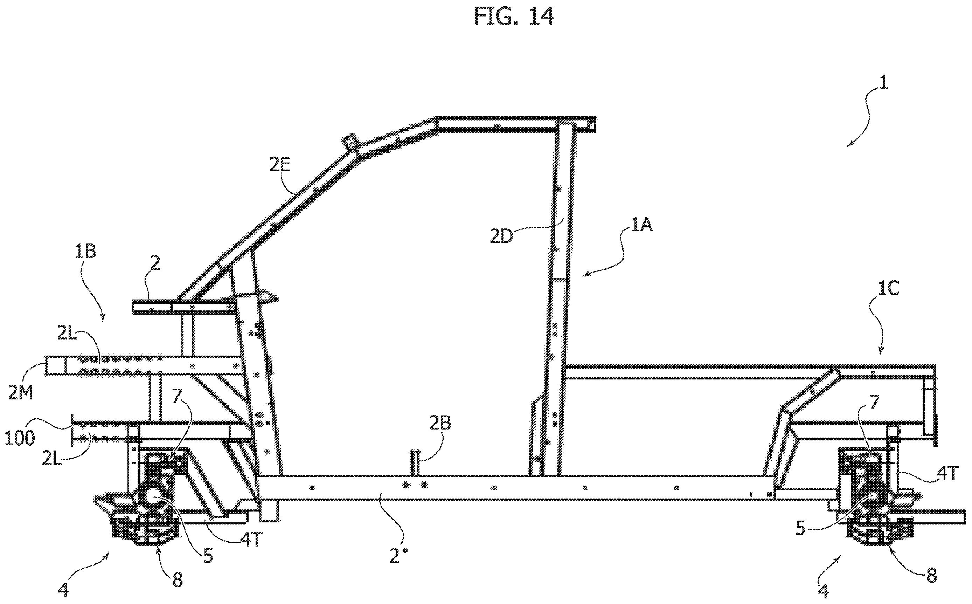

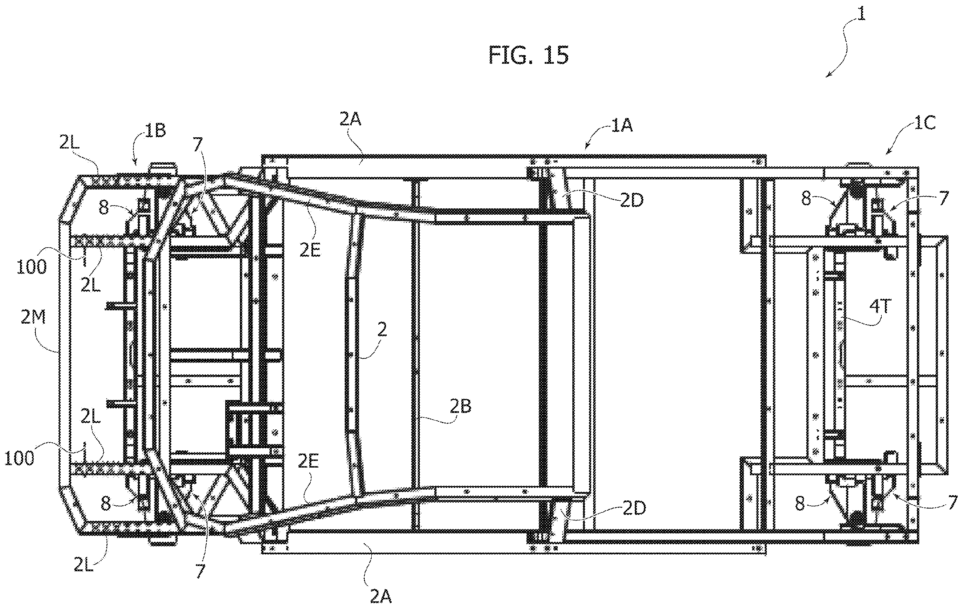

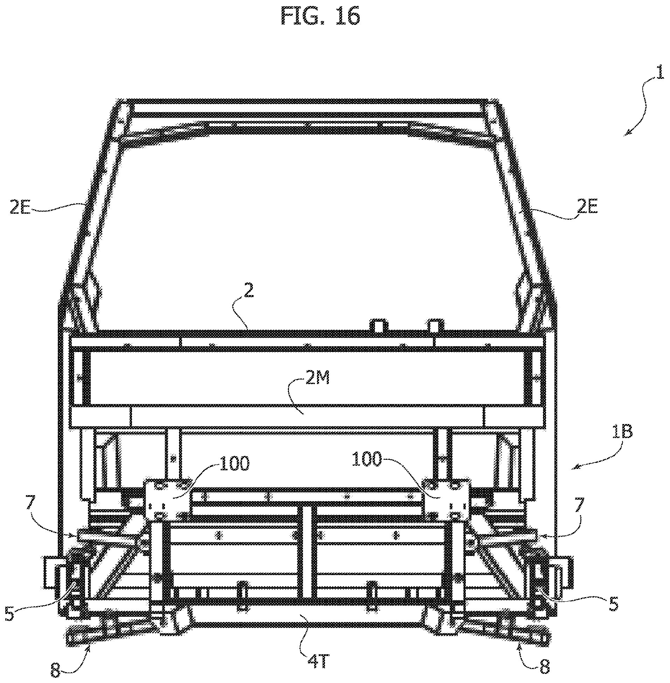

The frame 1 of the pick-up vehicle 24 is visible in Figures 12-17. In this case as well, as in the case of the configuration illustrated in Figure 1, a main cell module 1A is provided to which a front anti-crash frame module 1B and a rear frame module 1C are rigidly connected. In this case as well, the main cell module includes two lower side longitudinal members 2A to which the lower ends of two front uprights 2C and two central side uprights 2D are connected. The longitudinal members 2A are connected to each other by cross-members 2B.

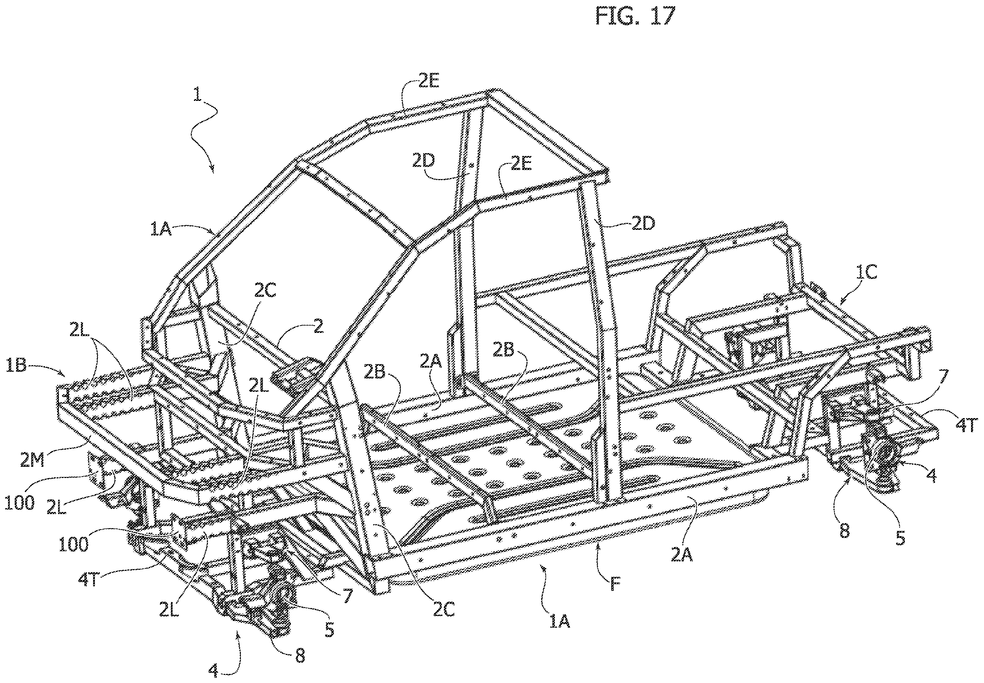

The structure of the front and rear frame modules 1B and 1C is entirely similar to that already described with reference to Figure 1. Therefore, in Figures 12-17, the parts common to those of Figures 1 are indicated by the same reference numbers. Figure 17 also shows the floor **F,** which also acts as a container for the battery pack, which is associated with the frame 1 of the vehicle.

With reference again to Figure 6, this Figure illustrates a pick-up vehicle configuration wherein a superstructure consisting of a single roll-bar 29 is arranged behind the cabin 25.

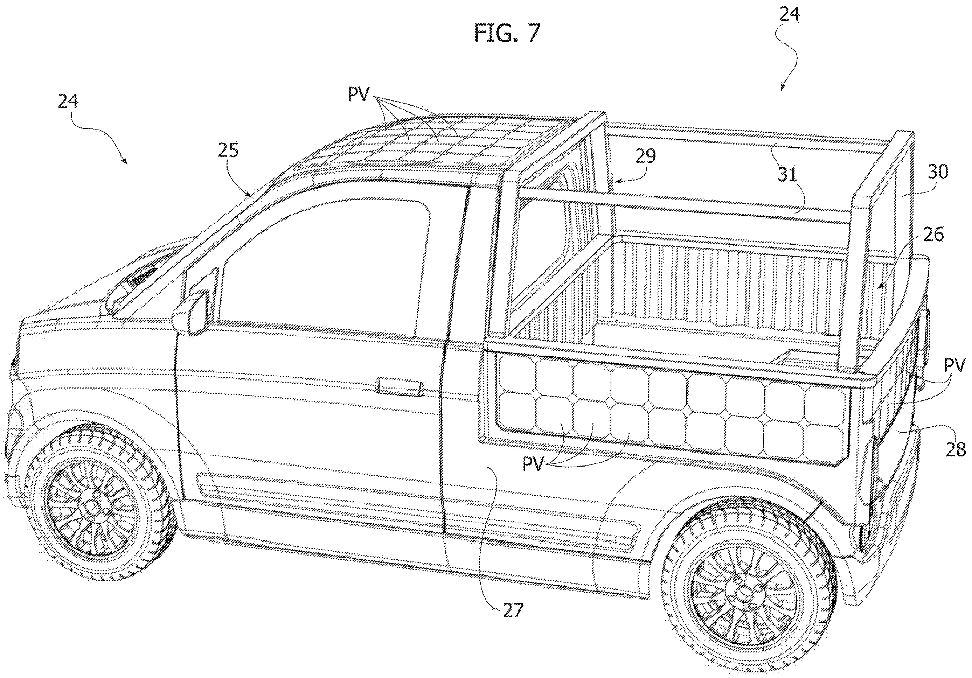

Figure 7 illustrates a variant wherein the superstructure arranged above the body 26 of the pick-up vehicle includes a front roll-bar 29 placed immediately behind the cab 25 and a rear roll-bar 30 arranged above the rear wall 28 of the body 26. Each of the two roll-bars 29, 30 consists of two uprights connected at the top by a cross-member. The upper ends of the uprights of the two roll-bars 29, 30 are also connected to each other by two longitudinal beams 31. Both in the configuration of Figure 6 and in the configuration of Figure 7, photovoltaic cell panels PV are arranged not only on the outer walls 27, 28 of the body 26, but also on the roof of the cabin 25.

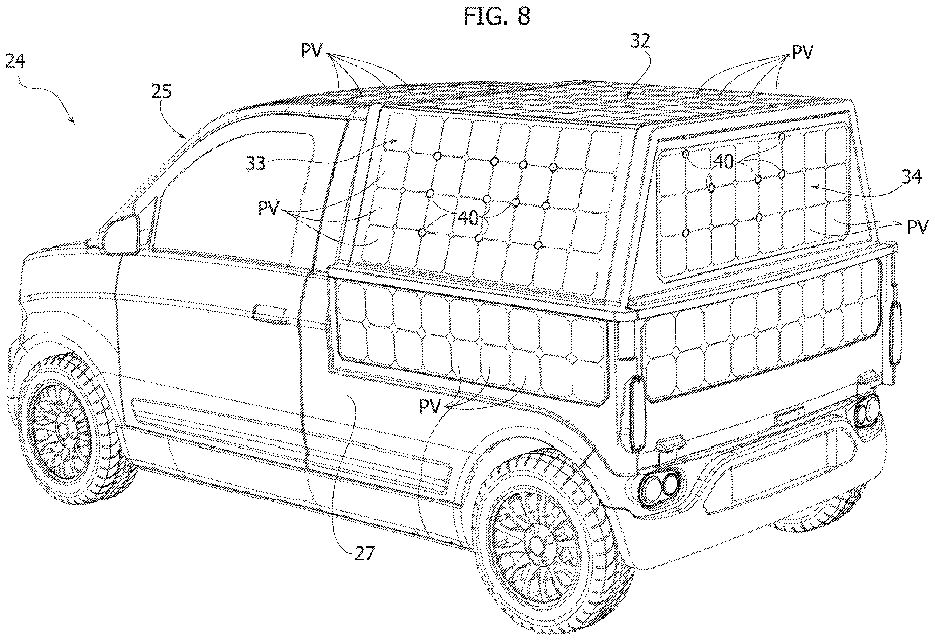

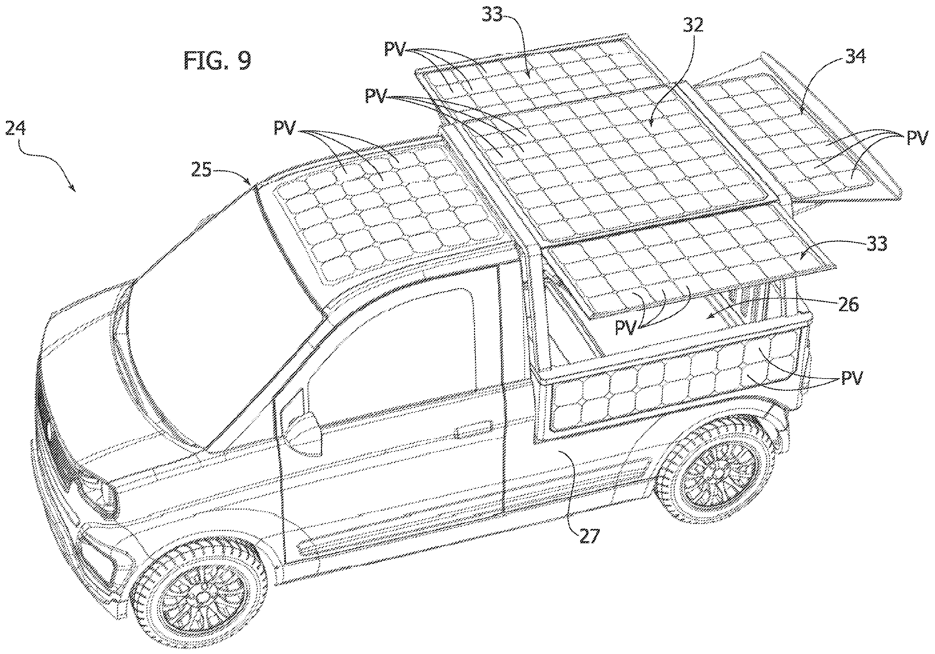

Figure 8 shows an additional variant wherein the space defined by the superstructure of the body 26 is delimited by an upper panel 32 of photovoltaic cells PV, by two side panels 33 and by a rear panel 34. The two side panels 33 and the rear panel 34 are movable between the lowered position illustrated in Figure 8, wherein they define a closed space above the body 26, and the raised position illustrated in Figure 9, wherein they are rotated upwards around their upper horizontal edges.

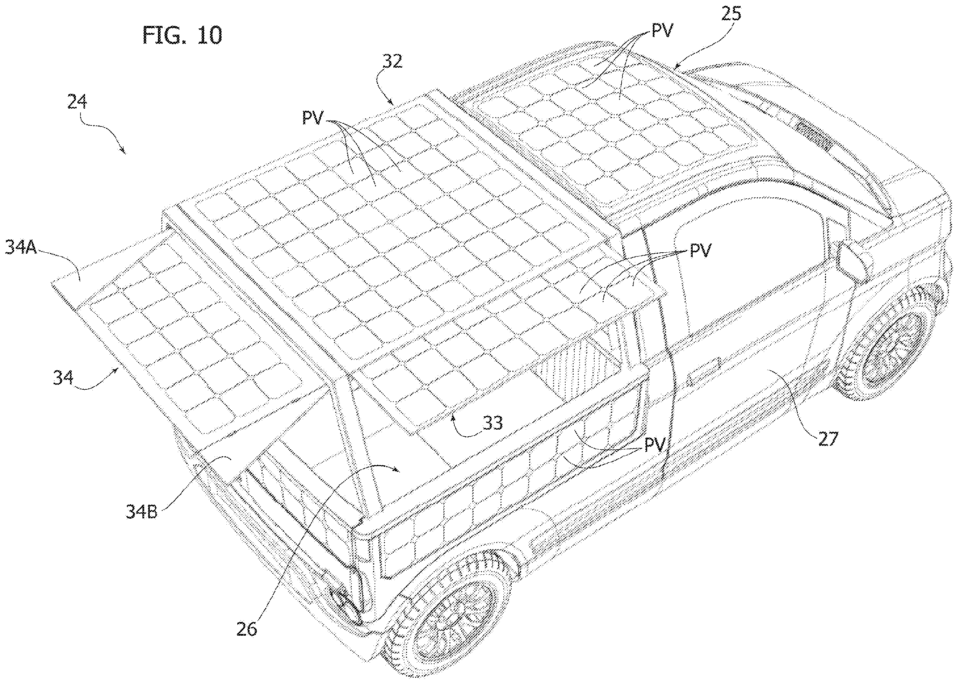

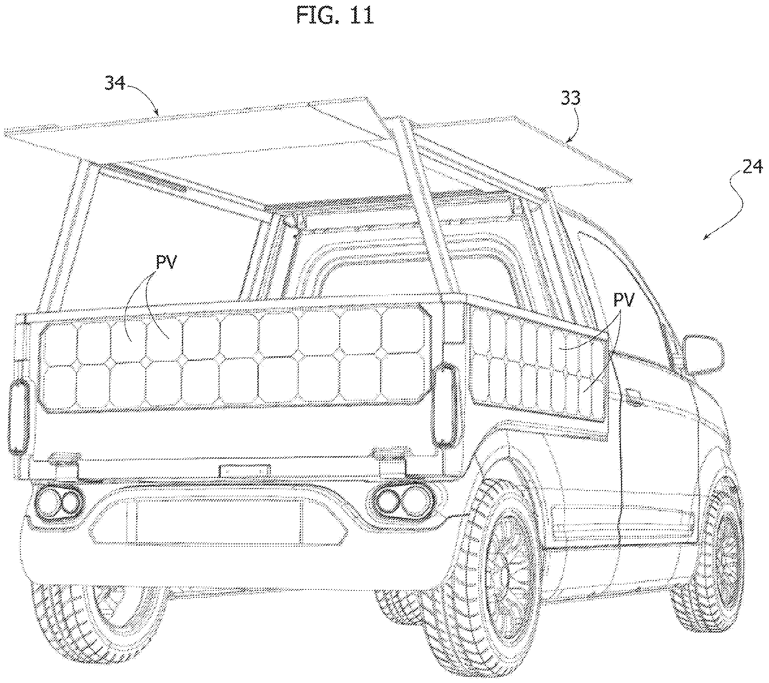

Figures 10, 11 illustrate a variant of Figures 8, 9 wherein the side panels 33, when they are in their raised position illustrated in Figure 9, are also able to slide underneath the upper panel 32 defining the roof of the space above the body. In the case of the variant of Figures 10, 11, the rear panel 34 may have side wings 34A that can be folded under the main part of the panel, to allow the rear panel 34 to slide under the upper panel 32 as well.

Again with reference to Figure 8, each of the side panels 33 and the rear panel 34 have an ordered distribution in rows and columns of photovoltaic cells PV separated by cell-free strips. Passive display elements 40, for example, colored or reflective, or active, such as LED light sources, can be arranged at the intersections between the cell-free strips, which can be used to display writings or logos on the panels 33, 34.

### The floor

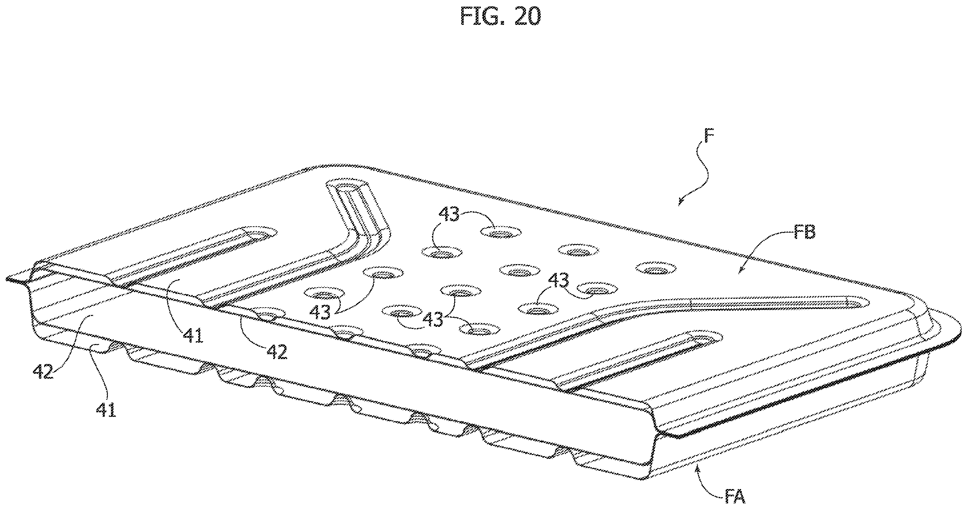

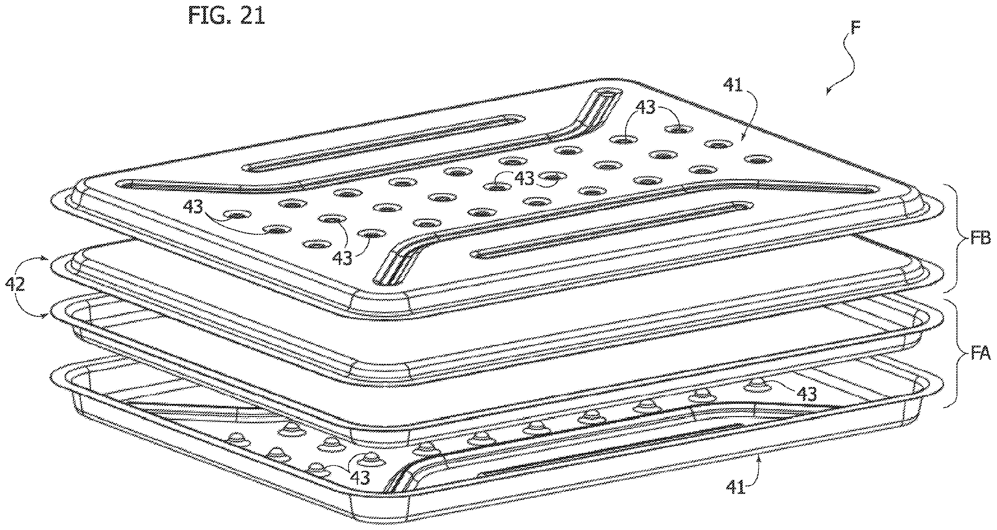

Figures 20, 21 show the preferred structure for the floor F, which also acts as a container for the battery pack. According to this solution, the floor-container F has a structure including a lower container body FA and an upper container body FB. Each of the bodies FA, FB is formed by two steel sheet panels 41, 42 parallel to each other and spaced apart, shaped by cutting and bending of the sheet, so as to present a main bottom wall surrounded by two side walls and two end walls. All the panels making up the body of the container are welded together along the peripheral edge. Each of the two panels constituting each container body FA, FB has an ordered distribution of impressions 43, which act both as spacer elements between the two panels and as structural elements, also suitable for reducing vibrations. The chamber comprised between each pair of panels 41, 42 is preferably filled with thermally insulating material.

### Anti-crash arms

Still with reference to Figures 18, 12, 13, 14, 15, 17, the front frame module 1B includes longitudinal beams 2L for absorbing impact energy, each consisting of an arm of the aforesaid reticular structure, projecting forwards, and having a hollow body with a quadrangular cross-section, in such a way as to have four longitudinal edges Z. Each of said longitudinal beams 2L has a series of openings H1-H5 for controlling the impact deformation, formed on each of said longitudinal edges Z in spaced apart positions, said openings H1-H5 presenting a decreasing amplitude from the front end of the longitudinal beam 2L towards the rear end, so as to induce a progressive deformation of the beam following a front impact, starting from the front end towards the rear end.

### Balanced charging of the battery pack

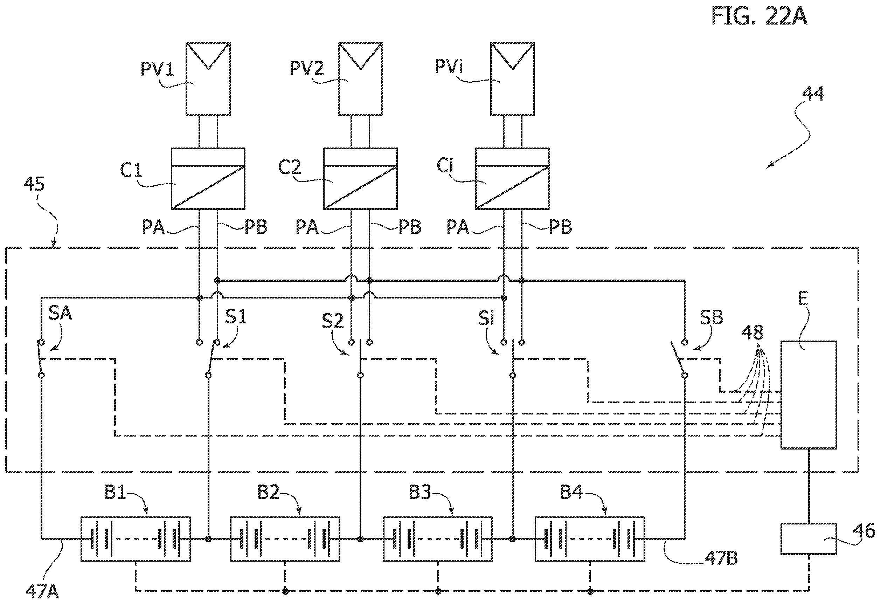

Figures 22A-22D illustrate four different operating conditions of an embodiment of a connection circuit between the photovoltaic cells with which the vehicle is provided, and the battery pack and which allows use of the energy generated by the photovoltaic cells for recharging the battery pack.

In the vehicle according to the invention, the battery pack for powering the electric drive motors of the vehicle comprises a plurality of battery modules Bi, four modules B1, B2, B3, B4 are shown in the example illustrated for the sake of simplicity.

In the embodiment illustrated here, the four battery modules B1-B4 are connected in series with each other, so that the voltage across the battery pack, for example, 48V, 120V, 240V, 360V, 420V is the sum of the voltages at the heads of the individual battery modules, for example 24V, 36V, 48V, 60V.

The recharging circuit of the battery modules B1-B4, indicated - in its entirety - with the reference 44, comprises a switching circuit 45 configured to connect one or more groups (panels) of photovoltaic cells PV1, PV2, ..., PVi selectively to any one of the battery modules B1, B2, B3, B4, in such a way that each battery module is supplied with current at the supply voltage of the single battery module, i.e. for example with 24V, 36V, 48V, 60V current. Each group or panel of photovoltaic cells PV1, PV2, ..., PVi is connected to the switching circuit 45 by means of a DC/DC converter C1, C2, ..., Ci, which carries the current from the supply voltage of the respective photovoltaic panel, for example, 9V or 24V, to the supply voltage of the single battery module, for example, 24V, 36V, 48V, 60V. A Battery Management System 46 is also associated with the vehicle battery pack, designed to check the state of charge of the individual battery modules B1, B2, B3, B4, and an electronic control and processing unit E configured and programmed to control the switching circuit 45 according to the state of charge of the individual battery modules, in such a way as to dynamically vary the battery module that is being recharged in order to actively balance the state of charge of the various battery modules.

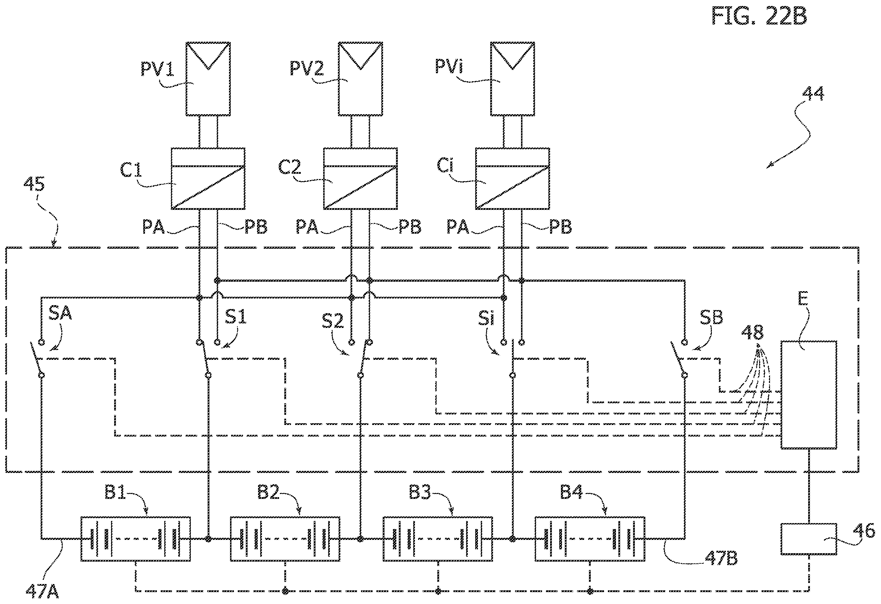

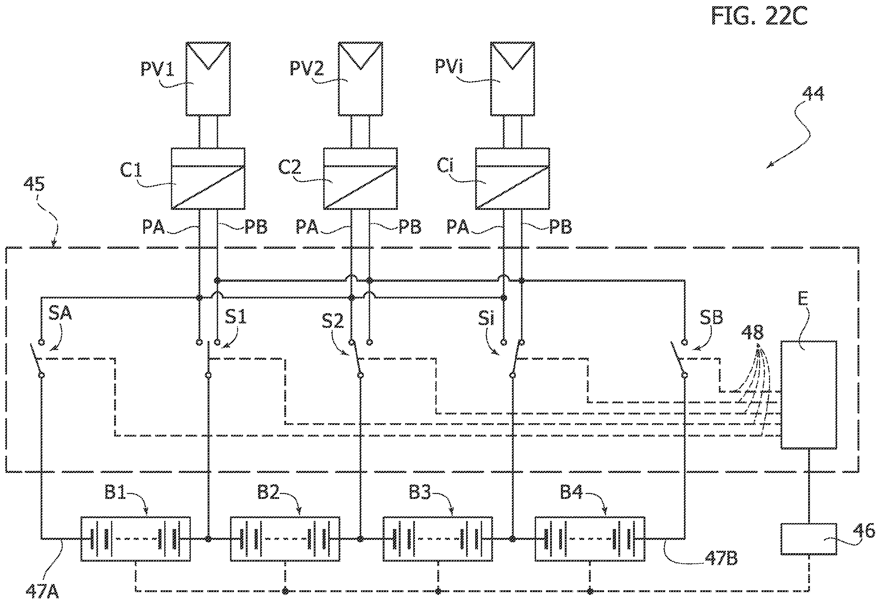

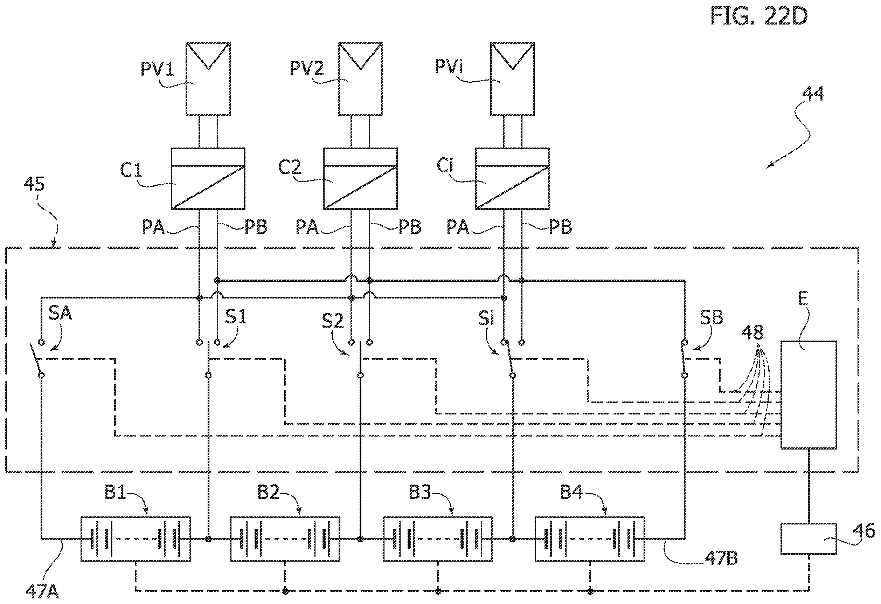

In the embodiment example of Figures 22A-22D, each DC/DC converter C1, C2,..., Ci has a first pole PA and a second pole PB at its output. The switching circuit 45 comprises a plurality of switches S1, S2, ..., Si, each designed to connect one of the two poles of a respective battery module with all the first output poles PA of the DC/DC converters or with all the second output poles PB of the DC/DC converters. Furthermore, the battery pack has an end pole 47A, which can be connected or disconnected to all the first output poles PA of the DC/DC converters by means of a switch SA, and a second end pole 47B, which can be connected or disconnected to all the second output poles PB of the DC/DC converters via a switch SB. The status of the switches S1, S2, ..., Si and SA, SB is controlled by CAN BUS lines 48, or more generally by signal communication lines from the electronic control and processing unit E on the basis of the signals received from the Battery System Management 46 according to the state of charge of the various battery modules B1, B2, B3, B4. Figure 22A illustrates a combination of the operating states of the different switches, so that only the battery module B1 is powered, with current generated by the photovoltaic panel PV1. Figure 22B shows the condition wherein only the battery module B2 is recharged, with current coming from the photovoltaic panel PV2. Figure 22C shows the operating condition wherein only the battery module B3 is recharged, with current generated from the photovoltaic panel PVi. Figure 22D shows the operating condition wherein the fourth battery module B4 is the only one to be recharged, by means of current generated from the photovoltaic panel PVi.

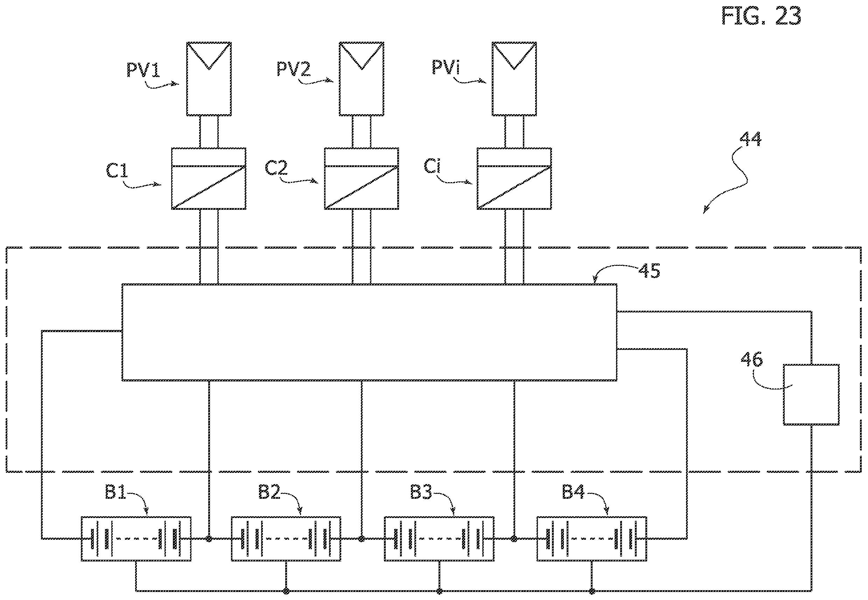

Figure 23 is a generalization of the diagram of Figures 22A-22D where the switching circuit 45 is schematized as a block. In the case of the diagram of Figure 23, it is the Battery Management System 46 that directly controls the switching circuit 45 as a function of the state of charge of the different battery modules.

As is evident from the above description, on the one hand, the recharging of the battery pack may be carried out more efficiently and by making use of simpler and less expensive components, since each DC/DC converter must supply current at a voltage that is the voltage across a single battery module. At the same time, the system according to the invention allows the recharging of the battery pack to be managed dynamically, keeping the state of charge of the various battery modules actively balanced as much as possible.

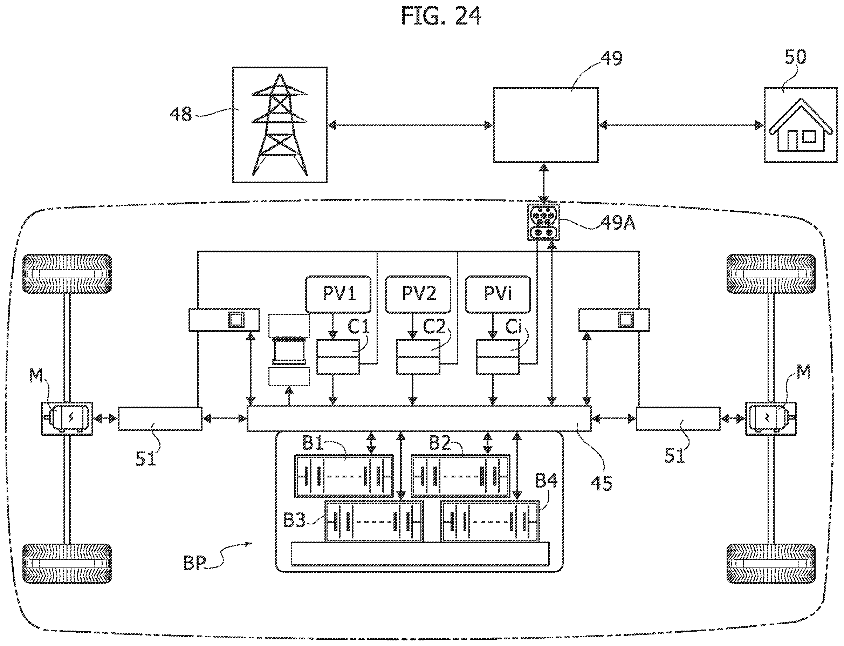

Figure 24 is an additional diagram of the connection circuit between the battery modules of the battery pack, the photovoltaic panels with which the vehicle is equipped, the front and rear drive electric motors of the vehicle, and the connector for charging the battery pack by means of an external power supply network. In Figure 24, the parts common to those of Figures 22, 23 are indicated by the same references. The reference BP indicates the entire battery pack comprising the battery modules B1, B2, B3, B4, connected to each other in series, which can be recharged by the photovoltaic cell panels PV1, PV2, ..., PVi by means of the DC/DC C1, C2,..., Ci and the switching circuit 45 whose operating condition is controlled by the Battery Management System 46. The circuit 45 is also connected to the connector 49A for coupling with an external power supply network 48 by means of a bidirectional charging device 49. The device 49 allows both recharging of the battery pack by the external power supply network 48 and, in the reverse direction, the use of electrical energy stored in the battery pack BP for feeding into the network 48 or supplying the electrical circuit of a house 50.

Again with reference to the diagram of Figure 24, an inverter 51 is associated with each drive electric motor M.

In the preferred embodiment, the Battery Management System is configured and programmed to inhibit the operation of the regenerative braking energy system when a state of charge of the battery modules of the battery pack is detected beyond a predefined limit. In this case, since there is no need to recharge the battery modules, the generation of generative energy is switched off during deceleration, during a descent or when braking the vehicle. In the latter case, braking is achieved in a conventional way, by actuating disc brakes associated with the wheels of the vehicle.

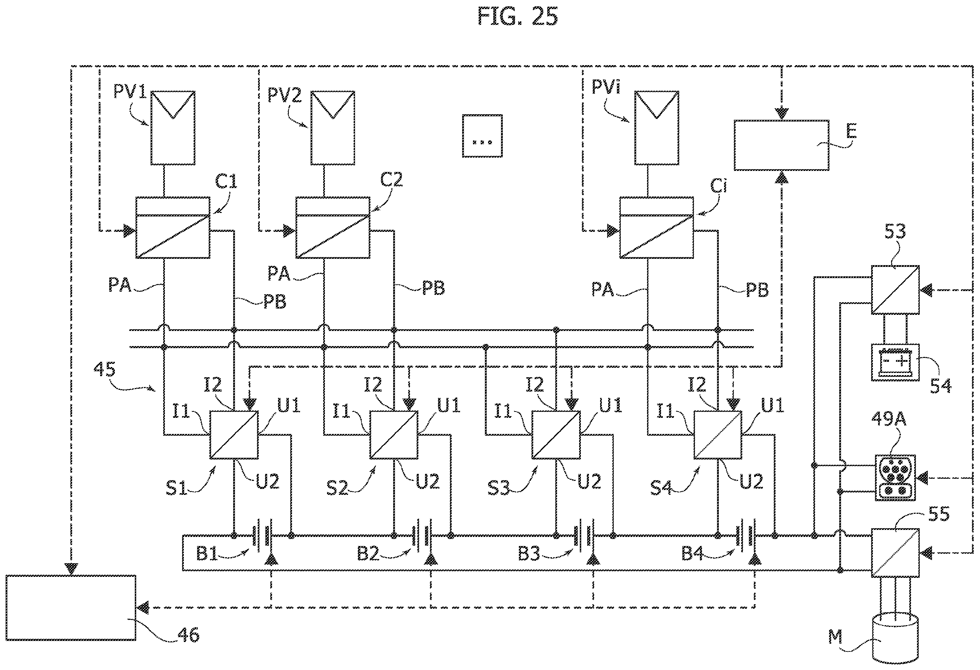

Figure 25 represents an additional and preferred embodiment, which is capable of optimizing the active balancing of the battery pack avoiding short-circuit situations.

In this case, the switching circuit 45 comprises a plurality of galvanic isolation circuits S1, S2, S3, S4 each having two input heads I1, I2 and two output heads U1, U2, The two input heads I1, I2 are connected one to all the output poles PA of the DC/DC converters, and the other to all the output poles PB of the DC/DC converters. The two output heads U1, U2 of each galvanic isolation circuit are connected to the poles of a respective battery module B1, B2, B3, B4, As in the case of the embodiment described above, the electronic unit E controls the DC/DC converters and the S1-S4 circuits as a function of the signals received by the Battery Management System 46 relating to the state of charge of the different battery modules, in order to activate the galvanic isolation circuits. The switching system 45 is able to selectively connect one or more of the photovoltaic cell panels with one or more of the battery modules so that the electronic unit E is able to dynamically manage the recharging of the different battery modules according to their state of charge, in order to keep the charge level of the different battery modules actively balanced. The diagram of Figure 25 also illustrates the connector 49A for recharging - by means of an external power supply network - a DC/DC converter 53 for recharging the battery 54 at 12 V of the on-board electrical circuit of the vehicle and a DC/AC inverter 55 for the power supply of the electric drive motors M through the battery pack.

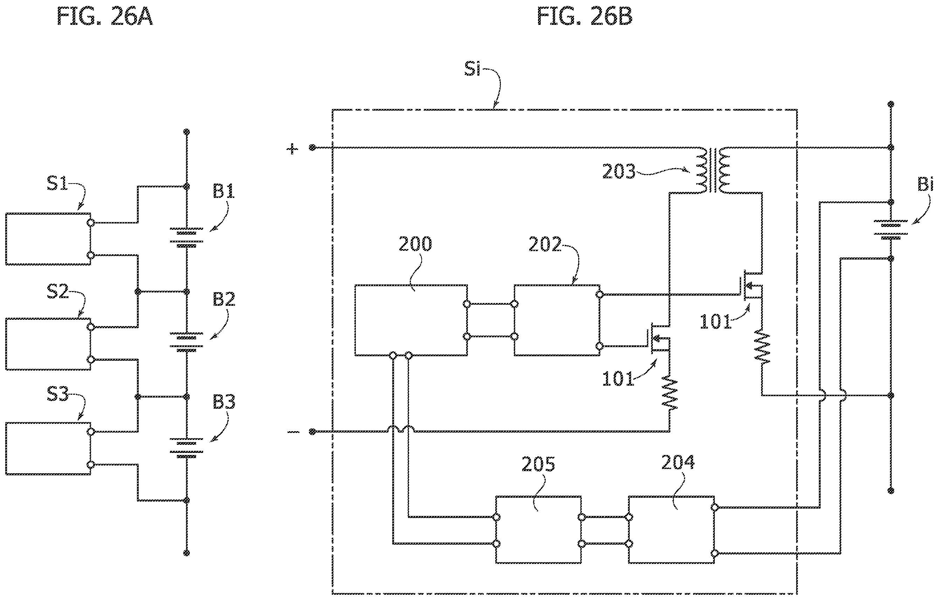

Figure 26A schematically shows three galvanically isolated charging circuits S1, S2 and S3 connected to three battery modules B1, B2 and B3, and Figure 26B shows a configuration example of a single circuit Si including a galvanically isolated circuit.

In known systems wherein the battery pack is recharged without balancing, the battery modules with the lowest state of charge reach full capacitance before the more charged battery modules.

With the active balancing achievable with the present invention, during the charge cycle, the battery can reach its full capacitance without unnecessary energy losses.

With reference to Figure 26B, the circuit Si comprises a galvanic isolation transformer 203 and an electronic controller 200 configured and programmed to control two power transistors (FET) 201 through a driver 202, which may include an optical type isolator. The controller 200 receives the signals from a voltage monitoring circuit 204 of the battery module Bi by means of a galvanic isolation circuit 205.

Each battery module Bi is charged by the circuit on the basis of the control carried out by the electronic control and processing unit E (Figure 25) by means of the controllers 200 of each circuit. It is thus possible to monitor the voltage of the individual battery modules and to implement a charging strategy that maintains a perfect balance of the modules.

In this way, the power of the photovoltaic panels (PV) may be transferred to the battery modules with a charge transfer efficiency greater than 90%.

During the entire charge cycle, each circuit communicates the state of charge of the respective battery module, so that no battery module becomes overcharged compared to the others.

In particular, it is not necessary to discharge an overcharged battery module, which avoids wasting energy.

Substantially, active balancing consists of injecting charge (current) into the battery module (for example, a single battery cell or a group of battery cells) with the lowest state of charge. This allows obtaining a similar state of charge in all battery modules and, therefore, pursuing an energy balance in all the elements. In doing this, the galvanic isolation in each series guarantees full safety on the side of the panel PV in all operating conditions.

### Variable configuration battery pack

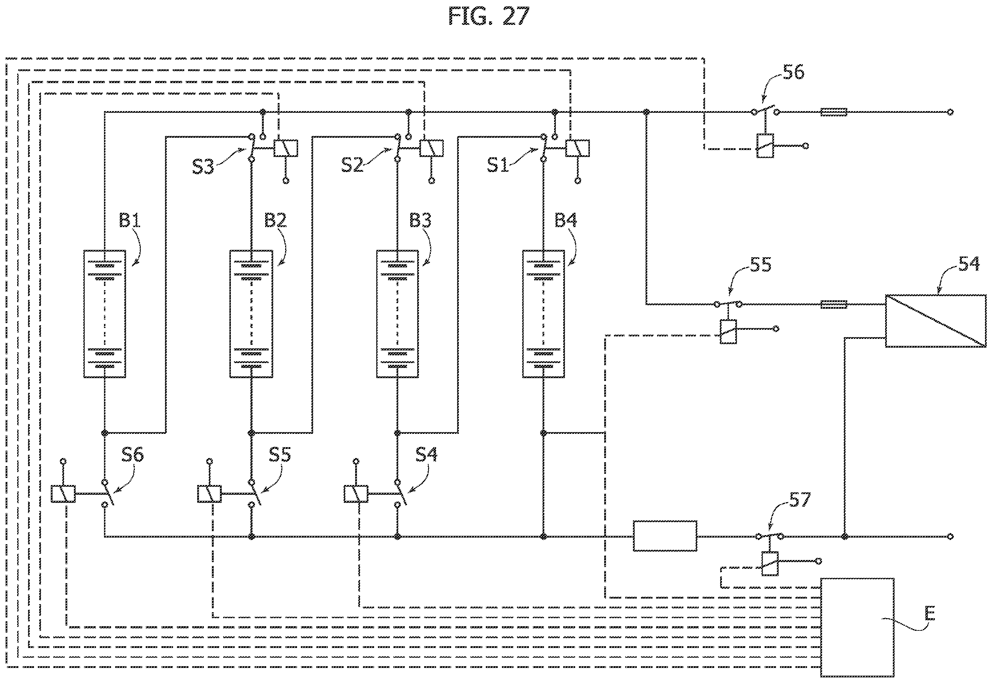

Figures 27-29 illustrate three different operating conditions of an electric vehicle which is not part of the invention, comprising a self-adaptive circuit for selecting the voltage value at which the battery pack operates for simplicity represented by the battery modules B1, B2, B3, B4. In this embodiment, the circuit comprises a plurality of connection switches S1, S2, S3, S4, S5, S6, which can each be switched between a first position and a second position by means of a respective solenoid controlled by the electronic control and processing unit E. Reference 54 indicates any source of energy for recharging the battery module, which can be constituted by the panels of photovoltaic cells, or by an external power supply network, or by the regenerative system that recovers the braking energy. The connection circuit also comprises a main switch 55 and an additional relay-switch 56 for connection to the inverter associated with the electric drive motor.

The electronic unit E checks the status of the different switches S1-S6 to produce different connection conditions of the battery modules in the different operating steps of the vehicle. Figure 27 shows a first operating condition wherein the battery modules are connected in series with each other. This configuration is optimal when charging the battery modules as it allows the power supply current to be kept low.

Thanks to the aforesaid characteristics, the battery modules are connected in series with each other during the recharging phase, in order to increase the recharge voltage (for example, 200V or 300V or 400V and more) and, therefore, keep the power supply current low in order to be able to increase the charging speed by reducing the stress of the battery cells. In the previous instant wherein recharging begins, the system of the switches prepares the entire pack to operate in the manner wherein the modules are connected in series.

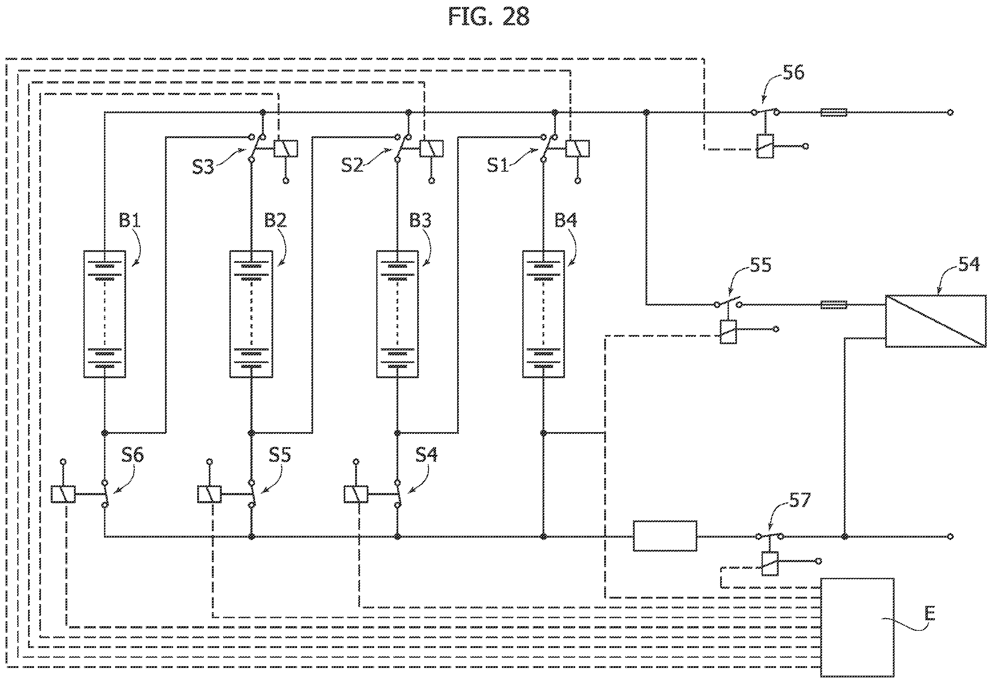

Figure 28 shows the operating condition wherein the battery modules are connected in parallel with each other. This condition is an optimal condition in the step of use with the vehicle in motion wherein the battery modules power the electric drive motors of the vehicle (the relay switch 56, which was open in the condition of Figure 27, is instead closed in the condition of Figure 28, while the main switch 55, which was closed in the condition of Figure 27 is open in the condition of Figure 28; the additional switch 57, which was closed in the condition of Figure 27 remains closed in the condition of Figure 28). Management of the switches enables hybrid solutions wherein modules are connected in series in pairs, and the two resulting pairs are connected in parallel.

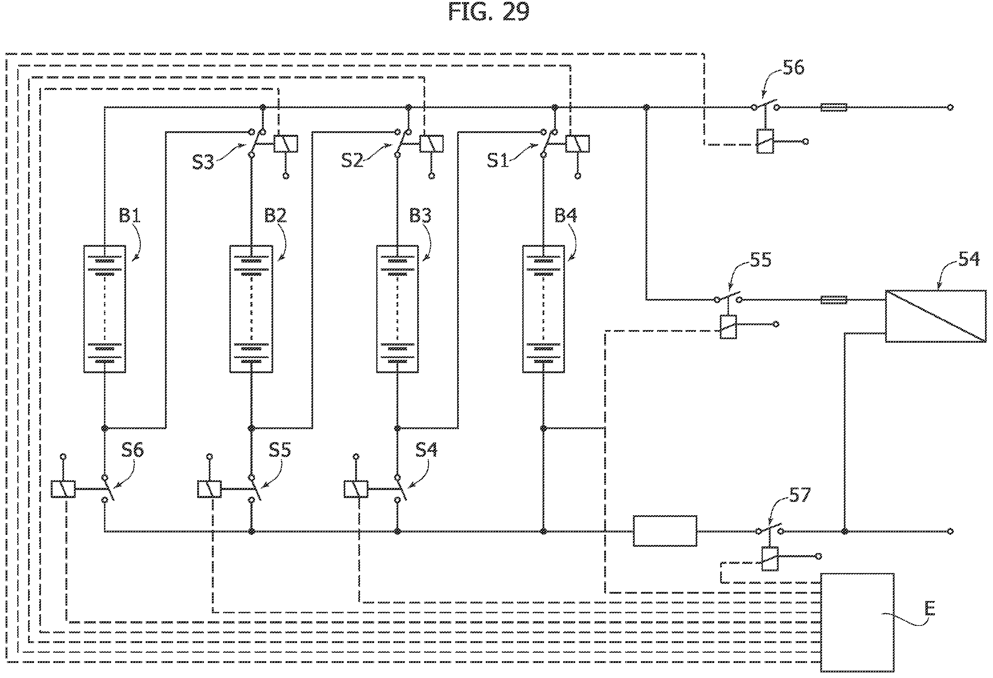

Figure 29 shows a third switching configuration, wherein the battery modules are isolated from each other. This condition is achieved when the electric vehicle is stationary with the electric motors inactive. In this condition, all three switches 56, 55 and 57 are open.

### Structure of photovoltaic panels

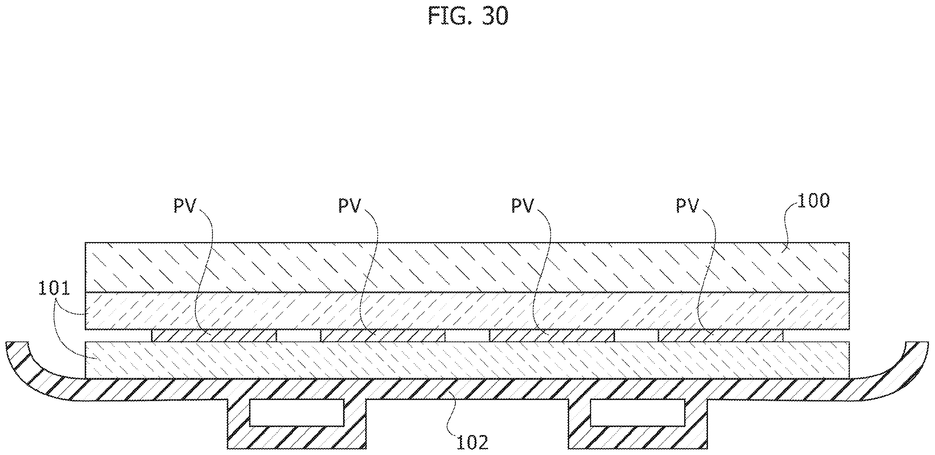

Figure 30 shows the stratified structure of any panel with which the vehicle according to the invention is equipped, carrying an array of photovoltaic cells. According to this solution, in each panel, the cells are incorporated in a layered laminar structure, including an outermost layer 100 facing the sun comprising one or more layers of PET with a UV or ECTFE coating, two layers of a thermoplastic polyolefin material 101, above and below the cells PV, to encapsulate the cells, and a rear rigid layer of structural glass fiber, which replaces the UV-coated PET panel, in place of which flexible panels are usually built. The composite panel thus composed is built in a vacuum chamber at a controlled temperature suitable for melting the intermediate layers of polyolefin material 101, avoiding the formation of air bubbles between the layers. The laminar sandwich composite is formed by keeping the transparent surface in contact with a smooth surface, while on the side consisting of the glass fiber it presses a membrane with such pressure as to ensure adhesion of the layers.

As is evident from the above description, the vehicle according to the invention has a series of innovative contents aimed - on the one hand - at drastically reducing the complexity of the vehicle structure and the costs of production equipment, at improving the degree of safety of the vehicle and the protection of the driver and passengers against the consequences of collisions, as well as - at the same time - identifying new vehicle configurations, such as the configuration of pick-up vehicles and vans, wherein arrangements of photovoltaic cell panels are made in combination with configurations that increase the functionality and ease of use of the vehicle. Furthermore, according to an additional aspect of the invention, improved forms of circuits have been developed for active recharging of the battery modules by means of photovoltaic panels. Other circuit forms allow a dynamic reconfiguration of the battery pack voltage and which - at the same time - increase both the efficiency of the recharging process and the safety level when the vehicle is stationary.

Of course, without prejudice to the principle of the invention, the embodiments and construction details may widely vary with respect to those described and illustrated purely by way of example, without thereby departing from the scope of the invention, as defined in the attached claims.

## Claims

1. An electric vehicle, in particular, an electric vehicle for transporting people, or a van or pick-up, comprising:
- a frame (1), including a main cell module (1A), a front anti-crash module (1B) rigidly connected to a front portion of the main cell module (1A) and a rear frame module (1C) rigidly connected to a rear portion of the main cell module (1A),
- wherein each of said frame modules (1A, 1B, 1C) consists of a reticular structure formed by high-strength steel arms (2), welded together, each arm (2) having a hollow structure with a quadrangular cross-section,
- a front axle unit (4) and a rear axle unit (4), each comprising:
- a frame (4T) rigidly connected to a respective front or rear frame module (1B, 1C),
- an upper pivoting arm (7) and a lower pivoting arm (8) for each wheel of the axle unit (4), mounted hinged to the frame (4T) of the axle unit and carrying a respective wheel support (5) in a rotatable way around a steering axis (6),
- a wheel hub (H) rotatably supported by each wheel support (5),
- an electric motor unit (M) carried by the frame (4T) of the axle unit and connected by means of transmission members (R, 10, 11, 12) to the wheel hubs (H) of said wheel supports (5), and
- a device (13) for activating the steering of the wheels, carried by the frame (4T) of the axle unit,
said vehicle further comprising a floor (F) rigidly connected to two lower side longitudinal members (2A) of said main cell module (1A) and configured to act as a structural element of the vehicle frame and also as a container for the battery pack (BP), for the electrical power supply of said electric motor assemblies (M) associated with the two axle units,
said vehicle being **characterized in that**:
- said upper pivoting arm (7) and said lower pivoting arm (8) associated with each wheel each have a main body (15) consisting of elements obtained from high-resistance steel tubes cut by laser cutting and welded together, with an upper main wall (16) and a lower main wall (17), both triangular in shape, parallel to each other and spaced apart, defining a base side of the triangular configuration at the ends of which two horizontal bushings are welded (18), coaxial with each other, for the articulated connection to the frame (4T) of the respective axle unit, and with an outer tip of the triangle configuration to which a vertical axis bushing (19) is welded for the articulated connection of the wheel support (5) around the steering axis (6), and
- also the wheel support (5), which is connected to said upper pivoting arm (7) and to said lower pivoting arm (8), has a main body (5A) consisting of tubular members of high-resistance steel welded together,
- a cylindrical ring (5B) for the rotatable support of the wheel hub is welded to said main body (5A) of the wheel support (5), and
- an upper attachment (5C) and a lower attachment (5D) are welded to said main body (5A) of the wheel support (5), said attachments being also made of high-strength steel tubes welded together, and being provided for receiving articulated supports for pivotal connection to the upper and lower pivoting arms (7, 8) around said steering axis (6).

2. An electric vehicle according to claim 1, **characterized in that** the two axle units have independent motor units and including respective electric motors (M) identical to each other, but associated with gearbox assemblies (R) configured to achieve different transmission ratios, for example 1: 9 and 1: 6.5, respectively.

3. An electric vehicle according to claim 1, **characterized in that** the aforesaid floor (F) also acting as a container for the battery pack (BP) has a structure including a lower container body (FA) and an upper container body (FB) having peripheral edges rigidly connected to each other,
wherein each of said lower and upper container bodies (FA, FB) is formed by two metal sheet panels (41, 42) parallel to each other and spaced apart, shaped by cutting and bending, so as to present a main bottom wall surrounded by two side walls and two end walls,
wherein one or both of the two metal sheet panels (41) of each container body (FA, FB) has an ordered distribution of imprints (43) which act as spacer elements between the two panels (41, 42), and
wherein the space between the two panels (41, 42) of each of said lower and upper container bodies (FA, FB) is filled with insulating material.

4. An electric vehicle according to any one of the preceding claims, **characterized in that** said front frame module (1B) includes longitudinal beams (2L) for absorbing impact energy, each consisting of an arm of the aforesaid reticular structure protruding forwards and having a hollow body with a quadrangular cross-section, so as to have four longitudinal edges (Z), and
**in that** each of said longitudinal beams (2L) has a series of openings (H1-H5) for controlling the impact deformation, formed on each of said longitudinal edges (Z) in spaced apart positions, said openings (H1-H5) presenting a decreasing amplitude from the front end of the longitudinal beam (2L) towards the rear end, so as to induce a progressive deformation of the beam following a front impact, starting from the front end towards the rear end.

5. An electric vehicle according to claim 1, **characterized in that** it comprises at least two front doors, articulated to the cell module (1A), each comprising a door frame-skeleton (21) having opposite faces covered by an inner door structure (22) and by an outer door structure (23),
- wherein the door frame-skeleton (21) includes a reticular structure similar to that of the aforesaid frame modules (1A, 1B, 1C), formed by high-strength steel arms, welded together, each arm having a hollow structure with quadrangular cross-section,
- wherein said arms constituting the door frame (21) include at least one front upright (21A), and one rear upright (21B), which are rigidly connected to each other by an upper cross-member (21C), by a lower cross member (21D) and a diagonal arm (21E),
- wherein each door includes a window frame including guide elements (24, 25, 26) substantially forming an arch, which has its opposite ends rigidly connected to said upper cross member (21C) of the door frame (21), and
- wherein the inner door structure (22) and the outer door structure (23) are constituted by steel sheet panels rigidly connected on opposite sides to said door frame (21) and including - in one piece - respective window frames (22B, 23B), which clamp together the aforesaid window frame (24-26) connected to the upper cross-member of the door frame (21).

6. An electric vehicle according to claim 1, **characterized in that**:
- said vehicle frame has a configuration for a pick-up vehicle or van including a superstructure comprising a front roll-bar (29), a rear roll-bar (30) and two upper side longitudinal members (31) and **in that**:
- said structure supports:
- an upper panel of photovoltaic cells (32) serving as a roof,
- two side panels (33) of photovoltaic (PV) cells covering the two sides of said superstructure, and
- a rear panel (34) of photovoltaic (PV) cells covering the rear side of said superstructure, and
wherein said side panels (33) and said rear panel (34) are movable between a lowered configuration, wherein said panels cover the respective sides of said superstructure, so as to define a closed space, and a raised configuration, wherein the panels are rotated upward around their upper horizontal edge.

7. An electric vehicle according to claim 6, **characterized in that** - in their raised position - the side panels (33) and/or the rear panel (34) are arranged to slide under the upper panel (32) acting as a roof.

8. An electric vehicle according to claim 6, **characterized in that** the vehicle body is provided with auxiliary panels of photovoltaic cells arranged on the sides (27) and on the rear wall (28) of the vehicle, below the aforesaid superstructure.

9. An electric vehicle according to claim 6, **characterized in that** in each panel of photovoltaic cells, the cells are incorporated in a layered laminar structure, including an outermost layer (100) comprising one or more layers of PET with a UV or ECTFE coating, two layers of a thermoplastic polyolefin material (101), above and below the cells, to encapsulate the cells (PV), and a thin rear layer (102) of structural glass fiber.

10. An electric vehicle according to claim 6, **characterized in that** each panel of photovoltaic cells has an ordered distribution in rows and columns of photovoltaic (PV) cells separated by cell-free strips, and **in that** in at least some of the intersections between the aforesaid cell-free strips are arranged reflecting devices or LED light sources (40) configured to display as an assembly passive colored or reflective or active writings and logos through the LED sources.

11. An electric vehicle according to claim 1, **characterized in that** it comprises one or more outer surfaces covered by one or more panels of photovoltaic cells connected to a recharging circuit of the battery pack (BP), which powers the electric drive motors (M) of the vehicle,
**in that** said battery pack comprises a plurality of battery modules (B1, B2, B3, B4) connected in series with each other, so that the voltage across the battery pack is the sum of the voltage across the individual battery modules,
**in that** said recharging circuit comprises a switching circuit (45) configured to connect one or more groups or panels of said photovoltaic (PV) cells, selectively to any of said battery modules (B1, B2, B3, B4), in such a way that each battery module is supplied with current at the supply voltage of the single battery module, and
**in that** each group or panel of photovoltaic cells (PV) is connected to said switching circuit (45) by means of a DC/DC converter, which carries the current from the supply voltage of the photovoltaic cell (PV) to the supply voltage of the single module battery,
so that said DC-DC converter is simplified, efficient and economical, because it operates at a low level of multiplication between its input voltage and its output voltage.

12. A vehicle according to claim 11, **characterized in that** said battery pack (BP) is associated with a Battery Management System, designed to control the state of charge of the individual battery modules, and an electronic control and processing unit (E) configured and programmed to control said switching circuit (45) according to the state of charge of the individual battery modules (B1, B2, B3, B4), so that the battery pack is actively charged and balanced by the photovoltaic panels.

13. An electric vehicle according to claim 11, **characterized in that** each DC/DC converter (C1, C2, ..., Ci) has a first pole (PA) and a second pole (PB) at its output and **in that** said switching circuit (45) comprises a plurality of switches (S1, S2, ..., Si), each designed to connect one of the two poles of a respective battery module with all the first output poles (PA) of the DC/DC converters (C1, C2, ..., Ci) or with all the second output poles (PB) of the DC/DC converters.

14. An electric vehicle according to claim 11, **characterized in that**:
- each DC/DC converter has a first pole (PA) and a second pole (PB) at its output,
- said switching circuit (45) comprises a plurality of galvanic isolation circuits (S1, S2, S3, S4) each having two input heads (I1, I2) and two output heads (U1, U2),
- the two output heads (U1, U2) of each galvanic isolation circuit are connected to the two poles of a respective battery module (B1, B2, B3, B4),
- the two input heads (I1, I2) of each galvanic isolation circuit (S1, S2, S3, S4) are connected one to all the first output poles (PA) of said DC/DC converters, and the other to all the second output poles (PB) of said DC/DC converters.

15. An electric vehicle according to claim 11, **characterized in that** said battery pack is associated with a Battery Management System (46), designed to control the state of charge of the individual battery modules (B1-B4) and an electronic control and processing unit (E) configured and programmed to control the aforesaid galvanic isolation circuits (S1-S4) according to the state of charge of the individual battery modules (B1-B4), so that the individual battery modules have a dynamically and actively equalized state of charge.

## Patentansprüche

1. Elektrofahrzeug, insbesondere Elektrofahrzeug zur Personenbeförderung, Transporter oder Pick-up, umfassend:
- einen Rahmen (1), der ein Hauptzellenmodul (1A), ein vorderes Anti-Crash-Modul (1B), das starr mit einem vorderen Teil des Hauptzellenmoduls (1A) verbunden ist, und ein hinteres Rahmenmodul (1C) umfasst, das starr mit einem hinteren Teil des Hauptzellenmoduls (1A) verbunden ist,
- wobei jedes der Rahmenmodule (1A, 1B, 1C) aus einer netzartigen Struktur besteht, die aus miteinander verschweißten Armen (2) aus hochfestem Stahl gebildet ist, wobei jeder Arm (2) eine Hohlstruktur mit viereckigem Querschnitt aufweist,
- eine Vorderachseinheit (4) und eine Hinterachseinheit (4), jeweils umfassend:
- einen Rahmen (4T), der starr mit einem jeweiligen vorderen oder hinteren Rahmenmodul (1B, 1C) verbunden ist,
- einen oberen Schwenkarm (7) und einen unteren Schwenkarm (8) für jedes Rad der Achseinheit (4), die gelenkbildend am Rahmen (4T) der Achseinheit montiert sind und einen jeweiligen Radträger (5) drehbar um eine Lenkachse (6) tragen,
- eine von jedem Radträger (5) drehbar getragene Radnabe (H),
- eine Elektromotoreinheit (M), die von dem Rahmen (4T) der Achseinheit getragen wird und über Übertragungselemente (R, 10, 11, 12) mit den Radnaben (H) der Radträger (5) verbunden ist, und
- eine Vorrichtung (13) zum Aktivieren der Lenkung der Räder, die von dem Rahmen (4T) der Achseinheit getragen wird,
wobei das Fahrzeug ferner einen Boden (F) umfasst, der starr mit zwei unteren seitlichen Längselementen (2A) des Hauptzellenmoduls (1A) verbunden ist und ausgebildet ist, als Strukturelement des Fahrzeugrahmens und auch als Behälter für das Batteriepaket (BP) für die Stromversorgung der den beiden Achseinheiten zugeordneten Elektromotoreinheiten (M) zu wirken,
wobei das Fahrzeug **dadurch gekennzeichnet ist, dass**:
- der obere Schwenkarm (7) und der untere Schwenkarm (8), die jedem Rad zugeordnet sind, jeweils einen Hauptkörper (15) aufweisen, der aus Elementen besteht, die aus hochfesten Stahlrohren gewonnen wurden, die durch Laserschneiden geschnitten und zusammengeschweißt wurden, mit einer oberen Hauptwand (16) und einer unteren Hauptwand (17), die beide dreieckig geformt und parallel zueinander und voneinander beabstandet sind, und eine Basisseite der dreieckigen Konfiguration definieren, an deren Enden zwei horizontale Buchsen (18) angeschweißt sind, die koaxial zueinander sind, für die gelenkbildende Verbindung mit dem Rahmen (4T) der jeweiligen Achseinheit, und mit einer äußeren Spitze der Dreieckskonfiguration, an der eine vertikale Achsbuchse (19) für die gelenkbildende Verbindung des Radträgers (5) um die Lenkachse (6) angeschweißt ist, und
- auch der Radträger (5), der mit dem oberen Schwenkarm (7) und dem unteren Schwenkarm (8) verbunden ist, einen Hauptkörper (5A) aufweist, der aus miteinander verschweißten Rohrelementen aus hochfestem Stahl besteht,
- ein zylindrischer Ring (5B) zur drehbaren Lagerung der Radnabe an den Hauptkörper (5A) des Radträgers (5) angeschweißt ist, und
- eine obere Befestigung (5C) und eine untere Befestigung (5D) an den Hauptkörper (5A) des Radträgers (5) geschweißt sind, wobei die Befestigungen auch aus zusammengeschweißten hochfesten Stahlrohren bestehen und zur Aufnahme von Gelenkstützen zur schwenkbaren Verbindung mit den oberen und unteren Schwenkarmen (7, 8) um die Lenkachse (6) herum vorgesehen sind.

2. Elektrofahrzeug nach Anspruch 1, **dadurch gekennzeichnet, dass** die beiden Achseinheiten unabhängige Motoreinheiten aufweisen und jeweils einen identischen Elektromotor (M) umfassen, denen aber Getriebeeinheiten (R) zugeordnet sind, die ausgebildet sind, unterschiedliche Übersetzungsverhältnisse zu erreichen, beispielsweise 1:9 bzw. 1:6,5.

3. Elektrofahrzeug nach Anspruch 1, **dadurch gekennzeichnet, dass** der vorgenannte Boden (F), der auch als Behälter für das Batteriepaket (BP) wirkt, eine Struktur aufweist, die einen unteren Behälterkörper (FA) und einen oberen Behälterkörper (FB) umfasst, deren Umfangskanten starr miteinander verbunden sind,
wobei jeder der unteren und oberen Behälterkörper (FA, FB) aus zwei parallel zueinander und beabstandeten Metallblechplatten (41, 42) besteht, die durch Schneiden und Biegen so geformt sind, dass sie eine Hauptbodenwand bilden, die von zwei Seitenwänden und zwei Stirnwänden umgeben ist,
wobei eine oder beide der beiden Metallblechplatten (41) jedes Behälterkörpers (FA, FB) eine geordnete Verteilung von Prägungen (43) aufweisen, die als Abstandselemente zwischen den beiden Platten (41, 42) wirkt, und
wobei der Raum zwischen den beiden Platten (41, 42) jedes der unteren und oberen Behälterkörper (FA, FB) mit Isoliermaterial gefüllt ist.

4. Elektrofahrzeug gemäß einem der vorhergehenden Ansprüche, **dadurch gekennzeichnet, dass** das vordere Rahmenmodul (1B) Längsträger (2L) zum Absorbieren von Aufprallenergie umfasst, die jeweils aus einem Arm der vorgenannten netzartigen Struktur bestehen, der vorwärts ragt und einen hohlen Körper mit einem viereckigen Querschnitt aufweist, sodass vier Längskanten (Z) vorhanden sind, und
dass jeder der Längsträger (2L) eine Reihe von Öffnungen (H1-H5) zum Steuern der Aufprallverformung aufweist, die an jeder der Längskanten (Z) in voneinander beabstandeten Positionen ausgebildet sind, wobei die Öffnungen (H1-H5) von dem vorderen Ende des Längsträgers (2L) zum hinteren Ende hin eine abnehmende Amplitude aufweisen, um nach einem Frontalaufprall eine fortschreitende Verformung des Trägers zu bewirken, die von dem vorderen Ende ausgehend zum hinteren Ende hin erfolgt.

5. Elektrofahrzeug nach Anspruch 1, **dadurch gekennzeichnet, dass** es mindestens zwei Vordertüren umfasst, die mit dem Zellmodul (1A) gelenkbildend verbunden sind, welche jeweils ein Türrahmenskelett (21) aufweisen, dessen gegenüberliegende Seiten von einer inneren Türstruktur (22) und einer äußeren Türstruktur (23) abgedeckt sind,
- wobei das Türrahmenskelett (21) eine netzartige Struktur ähnlich der der vorgenannten Rahmenmodule (1A, 1B, 1C) aufweist, die aus miteinander verschweißten Armen aus hochfestem Stahl geformt ist, wobei jeder Arm eine Hohlstruktur mit viereckigem Querschnitt aufweist,
- wobei die den Türrahmen (21) bildenden Arme mindestens einen vorderen Pfosten (21A) und einen hinteren Pfosten (21B) umfassen, die durch ein oberes Querelement (21C), ein unteres Querelement (21D) und einen diagonalen Arm (21E) starr miteinander verbunden sind,
- wobei jede Tür einen Fensterrahmen mit Führungselementen (24, 25, 26) aufweist, die im Wesentlichen einen Bogen bilden, dessen gegenüberliegende Enden starr mit dem oberen Querträger (21C) des Türrahmens (21) verbunden sind, und
- wobei die innere Türstruktur (22) und die äußere Türstruktur (23) aus Stahlblechplatten bestehen, die auf gegenüberliegenden Seiten starr mit dem Türrahmen (21) verbunden sind und - in einem Stück - jeweilige Fensterrahmen (22B, 23B) umfassen, die die vorgenannten Fensterrahmen (24-26) zusammenklemmen, die mit dem oberen Querträger des Türrahmens (21) verbunden sind.

6. Elektrofahrzeug nach Anspruch 1, **dadurch gekennzeichnet, dass**:
- der Fahrzeugrahmen eine Konfiguration für ein Pick-up-Fahrzeug oder einen Lieferwagen aufweist, einschließlich einer Überstruktur, die aus einem vorderen Überrollbügel (29), einem hinteren Überrollbügel (30) und zwei oberen seitlichen Längselementen (31) besteht, und dadurch, dass:
- die Struktur Folgendes trägt:
- eine obere Platte aus Photovoltaikzellen (32), die als Dach wirkt,
- zwei Seitenplatten (33) aus Photovoltaik- (PV) Zellen, die die beiden Seiten des Überbaus bedecken, und
- eine Rückplatte (34) aus Photovoltaik- (PV) Zellen, die die Rückseite des Überbaus abdeckt, und
wobei die Seitenplatten (33) und die Rückplatte (34) zwischen einer abgesenkten Konfiguration, in der die Platten die jeweiligen Seiten des Überbaus abdecken, um einen geschlossenen Raum zu definieren, und einer angehobenen Konfiguration beweglich sind, in der die Platten um ihre obere horizontale Kante nach oben gedreht sind.

7. Elektrofahrzeug nach Anspruch 6, **dadurch gekennzeichnet, dass** die Seitenplatten (33) und/oder die Rückplatte (34) in ihrer angehobenen Position so angeordnet sind, dass sie unter die als Dach wirkende obere Platte (32) gleiten.

8. Elektrofahrzeug nach Anspruch 6, **dadurch gekennzeichnet, dass** die Fahrzeugkarosserie mit zusätzlichen Platten aus Photovoltaikzellen ausgestattet ist, die an den Seiten (27) und an der Rückwand (28) des Fahrzeugs unterhalb des vorgenannten Aufbaus angeordnet sind.

9. Elektrofahrzeug nach Anspruch 6, **dadurch gekennzeichnet, dass** in jeder Platte aus Photovoltaikzellen die Zellen in einer mehrschichtigen Laminarstruktur eingebaut sind, die eine äußerste Schicht (100) aus einer oder mehreren Schichten aus PET mit einer UV- oder ECTFE-Beschichtung, zwei Schichten aus einem thermoplastischen Polyolefinmaterial (101), über und unter den Zellen, zum Einkapseln der Zellen (PV) und eine dünne hintere Schicht (102) aus Strukturglasfaser umfasst.

10. Elektrofahrzeug nach Anspruch 6, **dadurch gekennzeichnet, dass** jede Platte aus Photovoltaikzellen eine geordnete Verteilung in Reihen und Spalten von Photovoltaik- (PV) Zellen aufweist, die durch zellenfreie Streifen voneinander getrennt sind, und dass in zumindest einigen der Kreuzungspunkte zwischen den vorgenannten zellenfreien Streifen Reflektorvorrichtungen oder LED-Lichtquellen (40) angeordnet sind, die ausgebildet sind, als Baugruppe passiv farbige oder reflektierende oder aktive Schriftzüge und Logos durch die LED-Quellen anzuzeigen.

11. Elektrofahrzeug nach Anspruch 1, **dadurch gekennzeichnet, dass** es eine oder mehrere Außenflächen umfasst, die mit einem oder mehreren Platten aus Photovoltaikzellen bedeckt sind, die an einen Ladekreis des Batteriepakets (BP) angeschlossen sind, das die elektrischen Antriebsmotoren (M) des Fahrzeugs mit Strom versorgt,
dass das Batteriepaket eine Vielzahl in Reihe geschalteter Batteriemodule (B1, B2, B3, B4) umfasst, sodass die Spannung über das Batteriepaket der Summe der Spannungen an den einzelnen Batteriemodulen entspricht,
dass der Ladekreis einen Schaltkreis (45) umfasst, der ausgebildet ist, eine oder mehrere Gruppen oder Platten der Photovoltaikzellen (PV) selektiv mit einem der Batteriemodule (B1, B2, B3, B4) zu verbinden, sodass jedes Batteriemodul mit Strom mit der Versorgungsspannung des einzelnen Batteriemoduls versorgt wird, und
dass jede Gruppe oder jede Platte aus Photovoltaikzellen (PV) mittels eines DC/DC-Wandlers an den Schaltkreis (45) angeschlossen ist, der den Strom von der Versorgungsspannung der Photovoltaikzelle (PV) zur Versorgungsspannung der Einzelmodulbatterie führt,
sodass der DC-DC-Wandler vereinfacht, effizient und wirtschaftlich ist, da er mit einer geringen Multiplikation zwischen seiner Eingangsspannung und seiner Ausgangsspannung arbeitet.

12. Fahrzeug nach Anspruch 11, **dadurch gekennzeichnet, dass** das Batteriepaket (BP) mit einem Batteriemanagementsystem verbunden ist, das ausgebildet ist, den Ladezustand der einzelnen Batteriemodule zu steuern, sowie mit einer elektronischen Steuer- und Verarbeitungseinheit (E), die ausgebildet und programmiert ist, den Schaltkreis (45) entsprechend dem Ladezustand der einzelnen Batteriemodule (B1, B2, B3, B4) zu steuern, sodass das Batteriepaket durch die Photovoltaikmodule aktiv geladen und ausgeglichen wird.

13. Elektrofahrzeug nach Anspruch 11, **dadurch gekennzeichnet, dass** jeder DC/DC-Wandler (C1, C2, ..., Ci) an seinem Ausgang einen ersten Pol (PA) und einen zweiten Pol (PB) aufweist und dass der Schaltkreis (45) eine Vielzahl von Schaltern (S1, S2, ..., Si) umfasst, die jeweils ausgebildet sind, einen der beiden Pole eines jeweiligen Batteriemoduls mit allen ersten Ausgangspolen (PA) der DC/DC-Wandler (C1, C2, ..., Ci) oder mit allen zweiten Ausgangspolen (PB) der DC/DC-Wandler zu verbinden.

14. Elektrofahrzeug nach Anspruch 11, **dadurch gekennzeichnet, dass**:
- jeder DC/DC-Wandler an seinem Ausgang einen ersten Pol (PA) und einen zweiten Pol (PB) hat,
- der Schaltkreis (45) eine Vielzahl von galvanisch getrennten Schaltungen (S1, S2, S3, S4) mit jeweils zwei Eingangsköpfen (11, I2) und zwei Ausgangsköpfen (U1, U2) umfasst,
- die beiden Ausgangsköpfe (U1, U2) jeder galvanischen Trennschaltung mit den beiden Polen jeweils eines Batteriemoduls (B1, B2, B3, B4) verbunden sind,
- die beiden Eingangsköpfe (I1, I2) jeder galvanischen Trennschaltung (S1, S2, S3, S4) jeweils mit allen ersten Ausgangspolen (PA) der DC/DC-Wandler und jeweils mit allen zweiten Ausgangspolen (PB) der DC/DC-Wandler verbunden sind.

15. Elektrofahrzeug nach Anspruch 11, **dadurch gekennzeichnet, dass** dem Batteriepaket ein Batteriemanagementsystem (46) zugeordnet ist, das ausgebildet ist, den Ladezustand der einzelnen Batteriemodule (B1-B4) zu steuern, sowie eine elektronische Steuer- und Verarbeitungseinheit (E), die ausgebildet und programmiert ist, die vorgenannten galvanischen Trennschaltungen (S1-S4) entsprechend dem Ladezustand der einzelnen Batteriemodule (B1-B4) zu steuern, sodass die einzelnen Batteriemodule einen dynamisch und aktiv ausgeglichenen Ladezustand aufweisen.

## Revendications

1. Véhicule électrique, en particulier, un véhicule électrique pour le transport de personnes, ou une fourgonnette ou une camionnette, comprenant :
- un châssis (1), comprenant un module de cellule principal (1A), un module anti-collision avant (1B) relié de manière rigide à une partie avant du module de cellule principal (1A) et un module de châssis arrière (1C) relié de manière rigide à une partie arrière du module de cellule principal (1A),
- dans lequel chacun desdits modules de châssis (1A, 1B, 1C) est constitué d'une structure réticulaire formée par des bras en acier à haute résistance (2), soudés ensemble, chaque bras (2) présentant une structure creuse à section transversale quadrangulaire,
- une unité d'essieu avant (4) et une unité d'essieu arrière (4), chacune comprenant :
- un châssis (4T) relié de manière rigide à un module de châssis avant ou arrière (1B, 1C) respectif.
- un bras pivotant supérieur (7) et un bras pivotant inférieur (8) pour chaque roue de l'unité d'essieu (4), montés articulés au châssis (4T) de l'unité d'essieu et portant un support de roue (5) respectif de manière rotative autour d'un axe de direction (6),
- un moyeu de roue (H) supporté en rotation par chaque support de roue (5),
- une unité de moteur électrique (M) portée par le châssis (4T) de l'unité d'essieu et reliée au moyen d'organes de transmission (R, 10, 11, 12) aux moyeux de roue (H) desdits supports de roue (5), et
- un dispositif (13) pour activer la direction des roues, porté par le châssis (4T) de l'unité d'essieu,
ledit véhicule comprenant en outre un plancher (F) relié de manière rigide à deux organes longitudinaux latéraux inférieurs (2A) dudit module de cellule principal (1A) et configuré pour servir d'élément structurel du châssis de véhicule et également de conteneur pour le bloc-batterie (BP), pour l'alimentation électrique desdits ensembles moteurs électriques (M) associés aux deux unités d'essieu,
ledit véhicule étant **caractérisé en ce que** :
- ledit bras pivotant supérieur (7) et ledit bras pivotant inférieur (8) associés à chaque roue présentent chacun un corps principal (15) constitué d'éléments obtenus à partir de tubes en acier à haute résistance découpés au laser et soudés ensemble, avec une paroi principale supérieure (16) et une paroi principale inférieure (17), toutes deux de forme triangulaire, parallèles entre elles et espacées l'une de l'autre, définissant un côté de base de la configuration triangulaire aux extrémités duquel sont soudées deux douilles horizontales (18), coaxiales l'une à l'autre, pour la liaison articulée au châssis (4T) de l'unité d'essieu respective, et avec une pointe externe de la configuration triangulaire à laquelle une douille d'axe vertical (19) est soudée pour la liaison articulée du support de roue (5) autour de l'axe de direction (6), et
- également le support de roue (5), qui est relié audit bras pivotant supérieur (7) et audit bras pivotant inférieur (8), présente également un corps principal (5A) constitué d'organes tubulaires en acier à haute résistance soudés ensemble.
- une bague cylindrique (5B) pour le support rotatif du moyeu de roue est soudé audit corps principal (5A) du support de roue (5), et
- une fixation supérieure (5C) et une fixation inférieure (5D) sont soudées audit corps principal (5A) du support de roue (5), lesdites fixations étant également réalisées en tubes en acier à haute résistance soudés ensemble, et étant prévues pour recevoir des supports articulés pour une liaison pivotante aux bras pivotants supérieur et inférieur (7, 8) autour dudit axe de direction (6).

2. Véhicule électrique selon la revendication 1, **caractérisé en ce que** les deux unités d'essieu présentent des unités de moteur indépendantes et comprenant des moteurs électriques (M) respectifs identiques entre eux, mais associés à des ensembles boîtes de vitesses (R) configurés pour obtenir des rapports de transmission différents, par exemple 1:9 et 1:6,5, respectivement.

3. Véhicule électrique selon la revendication 1, **caractérisé en ce que** le plancher (F) précité servant également de conteneur pour le bloc-batterie (BP) présente une structure comprenant un corps de conteneur inférieur (FA) et un corps de conteneur supérieur (FB) présentant des bords périphériques reliés rigidement entre eux,
dans lequel chacun desdits corps de conteneur inférieur et supérieur (FA, FB) est formé par deux panneaux de feuille métallique (41, 42) parallèles entre eux et espacés l'un de l'autre, formés par découpage et pliage, de manière à présenter une paroi de fond principale entourée de deux parois latérales et de deux parois d'extrémité,
dans lequel l'un ou les deux panneaux de feuille métallique (41) de chaque corps de conteneur (FA, FB) présente/présentent une répartition ordonnée d'empreintes (43) qui servent d'éléments d'espacement entre les deux panneaux (41, 42), et
dans lequel l'espace entre les deux panneaux (41, 42) de chacun desdits corps de conteneur inférieur et supérieur (FA, FB) est rempli de matériau isolant.

4. Véhicule électrique selon l'une quelconque des revendications précédentes, **caractérisé en ce que** ledit module de châssis avant (1B) comprend des poutres longitudinales (2L) pour absorber l'énergie de choc, chacune étant constituée d'un bras de la structure réticulaire précitée faisant saillie vers l'avant et présentant un corps creux à section transversale quadrangulaire, de manière à présenter quatre bords longitudinaux (Z), et
**en ce que** chacune desdites poutres longitudinales (2L) présente une série d'ouvertures (H1-H5) pour commander la déformation due au choc, formées sur chacun desdits bords longitudinaux (Z) à des positions espacées, lesdites ouvertures (H1-H5) présentant une amplitude décroissante de l'extrémité avant de la poutre longitudinale (2L) vers l'extrémité arrière, de manière à induire une déformation progressive de la poutre après un choc frontal, en allant de l'extrémité avant vers l'extrémité arrière.

5. Véhicule électrique selon la revendication 1, **caractérisé en ce qu'**il comprend au moins deux portières avant, articulées au module de cellule (1A), chacune comprenant un encadrement-squelette de portière (21) présentant des faces opposées recouvertes d'une structure de portière interne (22) et d'une structure de portière externe (23),
- dans lequel l'encadrement-squelette de portière (21) comprend une structure réticulaire similaire à celle des modules de châssis (1A, 1B, 1C) précités, formée par des bras en acier à haute résistance, soudés ensemble, chaque bras présentant une structure creuse à section transversale quadrangulaire,
- dans lequel lesdits bras constituant l'encadrement de portière (21) comprennent au moins un montant avant (21A) et un montant arrière (21B), qui sont reliés entre eux de manière rigide par une traverse supérieure (21C), par une traverse inférieure (21D) et un bras diagonal (21E).
- dans lequel chaque portière comprend un encadrement de fenêtre comprenant des éléments de guidage (24, 25, 26) formant sensiblement un arc dont les extrémités opposées sont reliées de manière rigide à ladite traverse supérieure (21C) de l'encadrement de portière (21), et
- dans lequel la structure de portière interne (22) et la structure de portière externe (23) sont constituées par des panneaux en tôle d'acier reliés de manière rigide sur des côtés opposés audit encadrement de portière (21) et comprenant, en une seule pièce, des encadrements de fenêtre (22B, 23B) respectifs, qui fixent ensemble l'encadrement de fenêtre (24-26) précité relié à la traverse supérieure de l'encadrement de portière (21).

6. Véhicule électrique selon la revendication 1, **caractérisé en ce que** :
- ledit châssis de véhicule présente une configuration d'un véhicule de type camionnette ou d'une fourgonnette, comprenant une superstructure qui comprend un arceau de sécurité avant (29), un arceau de sécurité arrière (30) et deux organes longitudinaux latéraux supérieurs (31) and **en ce que** :
- ladite structure supporte :
- un panneau supérieur de cellules photovoltaïques (32) servant de toit,
- deux panneaux latéraux (33) de cellules photovoltaïques (PV) recouvrant les deux côtés de ladite superstructure, et
- un panneau arrière (34) de cellules photovoltaïques (PV) recouvrant le côté arrière de ladite superstructure, et
dans lequel lesdits panneaux latéraux (33) et ledit panneau arrière (34) sont mobiles entre une configuration abaissée, dans laquelle lesdits panneaux recouvrent les côtés respectifs de ladite superstructure, de manière à définir un espace fermé, et une configuration relevée, dans laquelle les panneaux sont tournés vers le haut autour de leur bord horizontal supérieur.

7. Véhicule électrique selon la revendication 6, **caractérisé en ce que** - dans leur position relevée - les panneaux latéraux (33) et/ou le panneau arrière (34) sont agencés pour coulisser sous le panneau supérieur (32) servant de toit.

8. Véhicule électrique selon la revendication 6, **caractérisé en ce que** la carrosserie de véhicule est pourvue de panneaux auxiliaires de cellules photovoltaïques agencés sur les côtés (27) et sur la paroi arrière (28) du véhicule, sous la superstructure précitée.

9. Véhicule électrique selon la revendication 6, **caractérisé en ce que** dans chaque panneau de cellules photovoltaïques, les cellules sont incorporées dans une structure laminaire en couches, comprenant une couche extérieure (100) qui comprend une ou plusieurs couches de PET avec un revêtement UV ou ECTFE, deux couches d'un matériau polyoléfine thermoplastique (101), au-dessus et en dessous des cellules, pour encapsuler les cellules (PV), et une fine couche arrière (102) de fibre de verre structurelle.

10. Véhicule électrique selon la revendication 6, **caractérisé en ce que** chaque panneau de cellules photovoltaïques présente une répartition ordonnée en rangées et colonnes de cellules photovoltaïques (PV) séparées par des bandes sans cellules, et **en ce que** dans au moins certaines des intersections entre les bandes sans cellules précitées, sont agencés des dispositifs réfléchissants ou des sources de lumière LED (40) configuré(e)s pour afficher en tant qu'ensemble des inscriptions et logos passifs colorés ou réfléchissants ou actifs à travers les sources LED.

11. Véhicule électrique selon la revendication 1, **caractérisé en ce qu'**il comprend une ou plusieurs surfaces externes recouvertes d'un ou de plusieurs panneaux de cellules photovoltaïques reliés à un circuit de recharge du bloc-batterie (BP), qui alimente les moteurs d'entraînement électriques (M) du véhicule,
**en ce que** ledit bloc-batterie comprend une pluralité de modules de batterie (B1, B2, B3, B4) reliés entre eux en série, de sorte que la tension aux bornes du bloc-batterie soit la somme de la tension aux bornes des modules de batterie individuels,
**en ce que** ledit circuit de recharge comprend un circuit de commutation (45) configuré pour relier un ou plusieurs groupes ou panneaux desdites cellules photovoltaïques (PV), sélectivement à l'un desdits modules de batterie (B1, B2, B3, B4), de manière à ce que chaque module de batterie soit alimenté en courant à la tension d'alimentation du module de batterie unique, et
**en ce que** chaque groupe ou panneau de cellules photovoltaïques (PV) est relié audit circuit de commutation (45) au moyen d'un convertisseur CC/CC, qui transporte le courant de la tension d'alimentation de la cellule photovoltaïque (PV) à la tension d'alimentation de la batterie de module unique,
de sorte que ledit convertisseur CC/CC soit simplifié, efficace et économique, car il fonctionne à un faible niveau de multiplication entre sa tension d'entrée et sa tension de sortie.

12. Véhicule selon la revendication 11, **caractérisé en ce que** ledit bloc-batterie (BP) est associé à un Système de Gestion de Batterie, conçu pour commander l'état de charge des modules de batterie individuels, et à une unité de commande et de traitement électronique (E) configurée et programmée pour commander ledit circuit de commutation (45) en fonction de l'état de charge des modules de batterie individuels (B1, B2, B3, B4), de sorte que le bloc-batterie soit activement chargé et équilibré par les panneaux photovoltaïques.

13. Véhicule électrique selon la revendication 11, **caractérisé en ce que** chaque convertisseur CC/CC (C1, C2, ..., Ci) présente un premier pôle (PA) et un second pôle (PB) à sa sortie et **en ce que** ledit circuit de commutation (45) comprend une pluralité de commutateurs (S1, S2, ..., Si), chacun étant conçu pour relier l'un des deux pôles d'un module de batterie respectif à tous les premiers pôles de sortie (PA) des convertisseurs CC/CC (C1, C2, ..., Ci) ou à tous les seconds pôles de sortie (PB) des convertisseurs CC/CC.

14. Véhicule électrique selon la revendication 11, **caractérisé en ce que** :
- chaque convertisseur CC/CC présente un premier pôle (PA) et un second pôle (PB) à sa sortie,
- ledit circuit de commutation (45) comprend une pluralité de circuits d'isolation galvanique (S1, S2, S3, S4) présentant chacun deux bornes d'entrée (I1, I2) et deux bornes de sortie (U1, U2),
- les deux bornes de sortie (U1, U2) de chaque circuit d'isolation galvanique sont reliées aux deux pôles d'un module de batterie respectif (B1, B2, B3, B4),
- les deux bornes d'entrée (I1, I2) de chaque circuit d'isolation galvanique (S1, S2, S3, S4) sont reliées, l'une à tous les premiers pôles de sortie (PA) desdits convertisseurs CC/CC, et l'autre à tous les seconds pôles de sortie (PB) desdits convertisseurs CC/CC.

15. Véhicule électrique selon la revendication 11, **caractérisé en ce que** ledit bloc-batterie est associé à un Système de Gestion de Batterie (46), conçu pour commander l'état de charge des modules de batterie individuels (B1-B4) et à une unité de commande et de traitement électronique (E) configurée et programmée pour commander les circuits d'isolation galvanique (S1-S4) précités en fonction de l'état de charge des modules de batterie individuels (B1-B4), de sorte que les modules de batterie individuels présentent un état de charge égalisé de manière dynamique et active.
